(19) Europäisches Patentamt / European Patent Office / Office européen des brevets

(11) EP 4 497 540 A1

(12) **EUROPEAN PATENT APPLICATION**

(43) Date of publication:
29.01.2025 Bulletin 2025/05

(21) Application number: 24191275.7

(22) Date of filing: 26.07.2024

(51) International Patent Classification (IPC):
**B24B 37/24** (2012.01)   **B24B 53/017** (2012.01)

(52) Cooperative Patent Classification (CPC):
**B24B 37/24; B24B 53/017**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 26.07.2023   KR 20230097789
06.11.2023   KR 20230151483

(71) Applicant: SK enpulse Co., Ltd.
Pyeongtaek-si, Gyeonggi-do 17784 (KR)

(72) Inventors:
• SHIN, Yujin
17784 Gyeonggi-do (KR)
• YOON, Jongwook
17784 Gyeonggi-do (KR)
• SEO, Jangwon
17784 Gyeonggi-do (KR)
• KIM, Kyunghwan
17784 Gyeonggi-do (KR)

(74) Representative: Dehns
10 Old Bailey
London EC4M 7NG (GB)

(54) **POLISHING PAD WITH REDUCED DEFECT AND METHOD OF PREPARING A SEMICONDUCTOR DEVICE USING THE SAME**

(57)   In the polishing pad according to an embodiment, the particle size of debris obtained during conditioning and the zeta potential of a debris solution are adjusted to specific ranges. As a result, it is possible to minimize the occurrence of defects and scratches during a CMP process while reducing the size of debris, thereby maintaining excellent physical properties and performance of the polishing pad.

[Fig. 1]

## Description

### Technical Field

Embodiments relate to a polishing pad with reduced defects and scratches in a chemical mechanical planarization (CMP) process and to a process for preparing a semiconductor device using the same.

### Background Art

The chemical mechanical planarization (CMP) in a process for preparing semiconductors refers to a step in which a semiconductor substrate such as a wafer is fixed to a head and in contact with the surface of a polishing pad mounted on a platen, and the surface of the semiconductor substrate is then chemically treated by supplying a slurry while the platen and the head are relatively moved, to thereby mechanically planarize the irregularities on the surface of the semiconductor substrate.

A polishing pad is an essential member that plays an important role in such a CMP process. In general, a polishing pad is composed of a polyurethane resin and has grooves on its surface for a large flow of a slurry and pores for supporting a fine flow thereof.

For the preparation of such a polishing pad, a diisocyanate and a polyol are reacted to obtain a prepolymer, which is mixed with a curing agent and a foaming agent and then cured to obtain a polyurethane foam sheet. Thereafter, the upper and lower surfaces of the polyurethane foam sheet are sliced to the desired thickness to obtain an upper pad, grooves are formed in a specific shape using a tip or the like on the surface of the upper pad, and it is then bonded with a polyurethane lower pad to prepare a polishing pad.

The CMP process may be carried out several times in the process of preparing a semiconductor device. A semiconductor device comprises a plurality of layers, in which each layer comprises a complex and fine circuit pattern. In addition, in recent years, the sizes of individual chips of a semiconductor device have been reduced, and the pattern of each layer is evolving to be more complex and finer. Accordingly, in the process of preparing a semiconductor device, the purpose of the CMP process has been expanded not only for the purpose of planarizing the circuit wiring, but also for the separation of the circuit wiring and the application of improvement of the wiring surface, and the like. As a result, more sophisticated and reliable CMP performance is required.

During the CMP process using such a polishing pad, debris is formed by friction between the polishing surface and the semiconductor substrate or when the polishing surface is cut by a diamond disk for conditioning.

Prior Art Document

(Patent Document 1) Korean Laid-open Patent Publication No. 2016-0027075

### Disclosure of Invention

### Technical Problem

During a CMP process using a polishing pad, debris is formed by friction between the polishing surface and the semiconductor substrate or when the polishing surface is cut by a diamond disk for conditioning. Such debris causes defects and scratches on the polished surface during the CMP process.

Accordingly, as a result of research conducted by the present inventors, it has been discovered that the size of debris obtained from a polishing pad and the zeta potential characteristics have an impact on the occurrence of defects; and that as the above characteristics are adjusted to certain ranges, it is possible to minimize the occurrence of defects and scratches during a CMP process while maintaining excellent physical properties and performance of the polishing pad.

In addition, as a result of research conducted by the present inventors, it is possible to achieve a polishing pad with a reduced particle size of debris when UV light is irradiated during a CMP process and to minimize the occurrence of defects and scratches in semiconductor devices by irradiating UV light during a CMP process using these characteristics of the polishing pad.

Accordingly, an object of the embodiments relates to a polishing pad with reduced defects and to a process for preparing a semiconductor device using the same.

### Solution to Problem

According to an embodiment, there is provided a polishing pad, which comprises a polishing layer, wherein the polishing layer comprises a urethane-based prepolymer, a foaming agent, and a curing agent; when the polishing layer is conditioned for 10 minutes while deionized water is supplied at 300 cc/minute under the conditions of a platen speed of 93 rpm, a conditioner load of 9 lbs, a conditioner speed of 64 rpm, and a sweep of 19 times/minute, the D50 particle size of the debris obtained is 50 $\mu$m or less at a pH of 5.5; and the zeta potential of an aqueous solution containing the debris at a concentration of 0.01% by weight is -20 mV to 30 mV at a pH of 5.5.

According to another embodiment, there is provided a polishing pad, which comprises a polishing layer comprising a polyurethane resin, wherein when the polishing layer is conditioned while a ceria slurry is supplied at 250 ml/minute under the conditions of a platen speed of 93 rpm, a conditioner load of 9 lbs, a conditioner speed of 64 rpm, and a sweep of 19 times/minute, followed by irradiation with UV light with a wavelength of 100 nm to 380 nm at an intensity of 1 kW from a distance of 5 cm, the debris obtained satisfies the following Relationship (1).

$$D50 \ [0 \ \text{min}] > D50 \ [4 \ \text{min}] \ ... \ (1)$$

Here, D50 [0 min] is the D50 particle size of the debris obtained in the conditioning before the irradiation with UV light, and D50 [4 min] is the D50 particle size of the debris obtained upon the irradiation with UV light for 4 minutes after the conditioning.

According to still another embodiment, there is provided a process for preparing a semiconductor device, which comprises polishing the surface of a semiconductor substrate using the polishing pad.

According to still another embodiment, there is provided a process for preparing a semiconductor device, which comprises conditioning the polishing layer of the polishing pad the irradiation of UV light with a wavelength of 100 nm to 380 nm while chemically and mechanically polishing a semiconductor substrate using the polishing pad.

**Advantageous Effects of Invention**

In the polishing pad according to the embodiment, the size of debris obtained therefrom and the zeta potential characteristics are adjusted to specific ranges. As a result, it is possible to minimize the occurrence of defects and scratches during a CMP process while maintaining excellent physical properties and performance of the polishing pad.

The polishing pad according to the embodiment has the feature of a reduced particle size of debris as UV light is irradiated during a CMP process. Thus, it is possible to minimize the occurrence of defects and scratches in semiconductor devices by irradiating UV light during a CMP process using these characteristics of the polishing pad. In addition, since the polishing pad according to the embodiment has excellent characteristics such as polishing rate, it is possible to enhance CMP performance and yield when a semiconductor device is prepared using the polishing pad.

**Brief Description of Drawings**

Fig. 1 illustrates a process for preparing a semiconductor device using a polishing pad according to an embodiment.
Fig. 2 shows the occurrence of a defect caused by debris during the process for preparing a semiconductor device.
Fig. 3 shows a method of measuring the particle size of debris obtained from a polishing pad according to an embodiment.
Fig. 4 shows a method of measuring the zeta potential of an aqueous solution of debris obtained from a polishing pad according to an embodiment.
Figs. 5 and 6 each show the change in particle size of debris obtained from polishing pads according to the Examples and Comparative Examples with respect to irradiation time with UV.
Figs. 7 and 8 show the configuration of a device for irradiating UV light during a CMP process according to an embodiment.

**Detailed Description for Carrying out the Invention**

Hereinafter, various embodiments and examples will be described in detail with reference to the drawings.

In the following description of the embodiments, a detailed description of known functions and configurations incorporated herein will be omitted when it is determined that the description may make the subject matter of the embodiments rather unclear. In addition, for the sake of description, the sizes of individual elements in the appended drawings may be exaggeratedly depicted or omitted, and they may differ from the actual sizes.

In the present specification, when one component is described to be formed on/under another component or connected or coupled to each other, it covers the cases where these components are directly or indirectly formed, connected, or coupled through another component. In addition, it should be understood that the criterion for the terms on and under of each component may vary depending on the direction in which the object is observed.

In this specification, terms referring to the respective components are used to distinguish them from each other and are not intended to limit the scope of the embodiment. In addition, in the present specification, a singular expression is interpreted to cover a plural number as well unless otherwise specified in the context.

Throughout the present specification, the terms first, second, and the like are used to describe various components. But the components should not be limited by the terms. The terms are used for the purpose of distinguishing one element from another.

In the present specification, the term "comprising" is intended to specify a particular characteristic, region, step, process, element, and/or component. It does not exclude the presence or addition of any other characteristic, region, step, process, element and/or component, unless specifically stated to the contrary.

The molecular weight of a compound or polymer described in the present specification, for example, a number average molecular weight or a weight average molecular weight, is a relative mass based on carbon-12 as is well known. Although its unit is not described, it may be understood as a molar mass (g/mole) of the same numerical value, if necessary.

In the numerical range that limits the size, physical properties, and the like of components described in the present specification, when a numerical range limited with the upper limit only and a numerical range limited with the lower limit only are separately exemplified, it should be understood that a numerical range combining these upper and lower limits is also encompassed in the exemplary scope of the invention.

**Chemical mechanical polishing**

Semiconductor devices are prepared through chemical and mechanical polishing with a polishing pad.

The process for preparing a semiconductor device according to an embodiment comprises polishing the surface of a semiconductor substrate using a polishing pad.

Specifically, the process for preparing a semiconductor device may comprise providing the polishing pad according to an embodiment; and relatively rotating the polishing surface of the polishing layer and the surface of a semiconductor substrate while they are in contact with each other to polish the surface of the semiconductor substrate.

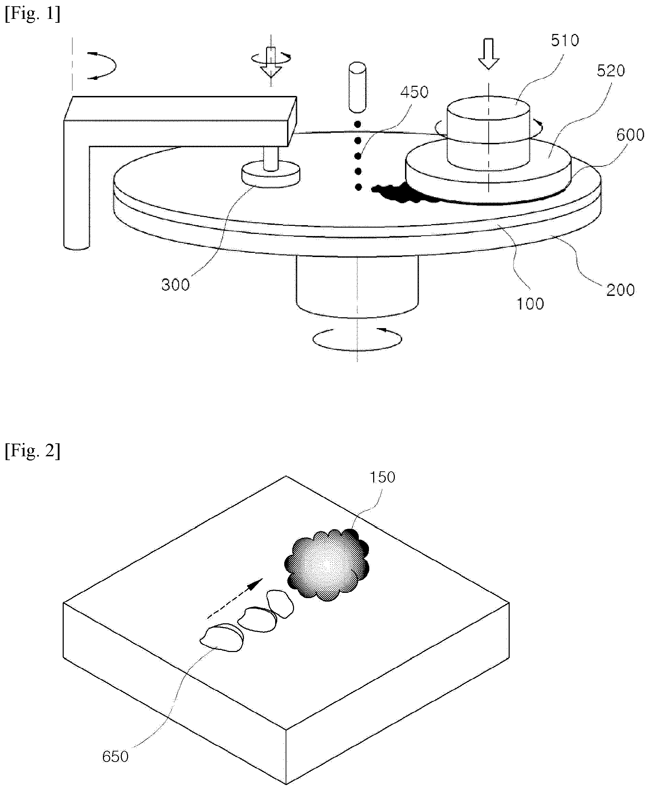

Fig. 1 illustrates a process for preparing a semiconductor device using the polishing pad according to an embodiment. Referring to Fig. 1, once the polishing pad (100) according to an embodiment has been attached to a platen (200), a semiconductor substrate (600) as an object to be polished is disposed on the polishing pad (100). In such an event, the surface of the semiconductor substrate (600) to be polished is in direct contact with the polishing surface of the polishing pad (100). A polishing slurry (450) may be sprayed through a nozzle onto the polishing pad for polishing. The flow rate of the polishing slurry (450) supplied through the nozzle may be selected according to the purpose within a range of about 10 cm$^3$/minute to about 1,000 cm$^3$/minute. For example, it may be about 50 cm$^3$/minute to about 500 cm$^3$/minute, but it is not limited thereto.

Thereafter, the semiconductor substrate (600) and the polishing pad (100) rotate relatively to each other, so that the surface of the semiconductor substrate (600) is polished. In such an event, the rotation direction of the semiconductor substrate (600) and the rotation direction of the polishing pad (100) may be the same direction or opposite directions. The rotation speeds of the semiconductor substrate (600) and the polishing pad (100) may each be selected according to the purpose within a range of about 10 rpm to about 500 rpm. For example, it may be about 30 rpm to about 200 rpm, but it is not limited thereto.

The semiconductor substrate (600) mounted on the polishing head (510) is pressed against the polishing surface of the polishing pad (100) at a predetermined load to be in contact therewith, and the surface thereof may then be polished. The load applied to the polishing surface of the polishing pad (100) and the surface of the semiconductor substrate (600) by the polishing head (510) may be selected according to the purpose within a range of about 1 gf/cm$^2$ to about 1,000 gf/cm$^2$. For example, it may be about 10 gf/cm$^2$ to about 800 gf/cm$^2$, but it is not limited thereto.

In an embodiment, the semiconductor substrate (600) as an object to be polished may comprise an oxide layer, a tungsten layer, or a composite layer thereof. Specifically, the semiconductor substrate (600) may comprise an oxide layer, a tungsten layer, or a composite layer of an oxide layer and a tungsten layer. The composite layer of an oxide layer and a tungsten layer may be a multilayer film in which the tungsten layer is laminated on one side of the oxide layer or may be a single-layer film in which an oxide region and a tungsten region are mixed in a single layer. As the object to be polished has such a film substance, and, at the same time, the polishing pad has characteristics according to the embodiment, a semiconductor device fabricated according to the process for preparing a semiconductor device may have minimum defects.

In an embodiment, the process for preparing a semiconductor device may further comprise, in the step of polishing the object to be polished, supplying any one of a slurry for polishing an oxide layer and a slurry for polishing a tungsten layer; or sequentially supplying the slurry for polishing an oxide layer and the slurry for polishing a tungsten layer to the polishing surface.

For example, if the semiconductor substrate as an object to be polished comprises an oxide layer, the process for preparing a semiconductor device may comprise supplying a slurry for polishing an oxide layer. If the semiconductor substrate comprises a tungsten layer, the process for preparing a semiconductor device may comprise supplying a slurry for polishing a tungsten layer. If the semiconductor substrate comprises a composite layer of an oxide layer and a tungsten layer, the process for preparing a semiconductor device may comprise sequentially supplying a slurry for polishing an oxide layer and a slurry for polishing a tungsten layer to the polishing surface. Here, depending on the process, the slurry for polishing an oxide layer may be supplied first and then the slurry for polishing a tungsten layer may be supplied later, or the slurry for polishing a tungsten layer may be supplied first and then the slurry for polishing an oxide layer may be supplied later.

In an embodiment, in order to maintain the polishing surface of the polishing pad (100) in a state suitable for polishing, the process for preparing a semiconductor device may further comprise processing the polishing surface of the polishing pad (100) with a conditioner (300) simultaneously with polishing the semiconductor substrate (600).

In the polishing pad according to an embodiment, the size of debris obtained from the polishing layer thereof and the zeta potential characteristics are adjusted to specific ranges. As a result, it is possible to minimize the occurrence of defects and scratches during a CMP process while maintaining excellent physical properties and performance of the polishing pad. Thus, it is possible to efficiently fabricate a semiconductor device of excellent quality using the polishing pad.

**Polishing pad**

The polishing pad according to an embodiment comprises a polishing layer. Specifically, the polishing pad comprises a polishing layer comprising a polyurethane resin.

Specifically, the polishing pad comprises a polishing layer and a support layer. In addition, an adhesive layer may be interposed between the polishing layer and the support layer.

Fig. 2 shows the occurrence of a defect caused by debris during the process for preparing a semiconductor device. Referring to Fig. 2, defects (650) or scratches are formed on the surface of a semiconductor device by debris (150) originating from the polishing layer. According to an embodiment, the size of the debris originating from the polishing layer and the zeta potential can be adjusted to specific ranges, thereby minimizing the occurrence of defects or scratches.

In the polishing pad according to an embodiment, debris obtained therefrom has a particle size within a specific range.

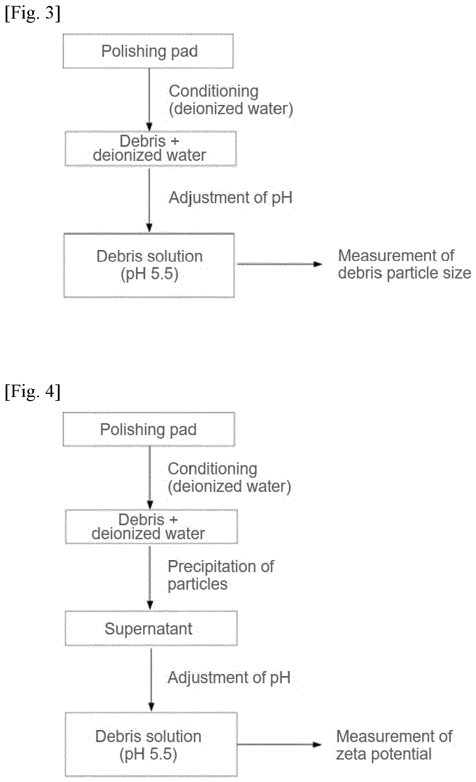

Fig. 3 shows a method of measuring the particle size of debris obtained from a polishing pad according to an embodiment. Referring to Fig. 3, a polishing pad is attached to the platen of a CMP polishing machine, the polishing layer is conditioned while deionized water is supplied, and the debris of the polishing layer formed after 10 minutes of conditioning is collected in the form of a solution mixed with deionized water. The pH of the aqueous solution of debris is adjusted using an aqueous nitric acid solution or an aqueous potassium hydroxide solution, and the particle size of the debris is then measured using a particle size analyzer.

Specifically, the debris may be obtained during the conditioning of the polishing layer of the polishing pad while supplying 300 cc/minute of deionized water under the conditions of a platen speed of 93 rpm, a conditioner load of 9 lbs, a conditioner speed of 64 rpm, and a sweep of 19 times/minute. The particle size of the debris may be an average particle size, i.e., a D50 particle size. As a specific example, a diamond disk (e.g., CI45 type disk from Saesol) with a pad cut rate (PCR) of 80 $\mu$m/hr to 90 $\mu$m/hr may be used in the conditioner.

The D50 particle size of debris may be measured using a particle size analyzer (e.g. Mastersize 3000, Malvern) and a medium-capacity automatic disperser (e.g. Hydro MV, Malvern).

According to an embodiment, the D50 particle size of debris obtained during the conditioning of the polishing layer for 10 minutes is 50 $\mu$m or less at a pH of 5.5.

Specifically, the D50 particle size of debris obtained when the polishing layer is conditioned for 10 minutes under the above conditions may be 40 $\mu$m or less, 30 $\mu$m or less, 25 $\mu$m or less, 22 $\mu$m or less, 20 $\mu$m or less, 19 $\mu$m or less, 18 $\mu$m or less, or 17 $\mu$m or less, and 5 $\mu$m or more, 10 $\mu$m or more, or 15 $\mu$m or more, at a pH of 5.5.

More specifically, the D50 particle size of debris obtained when the polishing layer is conditioned for 10 minutes under the above conditions may be 10 $\mu$m to 50 $\mu$m, 10 $\mu$m to 40 $\mu$m, 10 $\mu$m to 30 $\mu$m, 10 $\mu$m to 25 $\mu$m, 10 $\mu$m to 22 $\mu$m, 10 $\mu$m to 21 $\mu$m, 10 $\mu$m to 20 $\mu$m, 10 $\mu$m to 19 $\mu$m, 10 $\mu$m to 18 $\mu$m, or 10 $\mu$m to 17 $\mu$m, at a pH of 5.5.

According to another embodiment, the D50 particle size of debris obtained during the conditioning of the polishing layer for 10 minutes is 35 $\mu$m or less at a pH of 10.

Specifically, the D50 particle size of debris obtained when the polishing layer is conditioned for 10 minutes under the above conditions may be 35 $\mu$m or less, 30 $\mu$m or less, 25 $\mu$m or less, 24 $\mu$m or less, 23 $\mu$m or less, 22.3 $\mu$m or less, 22 $\mu$m or less, or 21 $\mu$m or less, and 5 $\mu$m or more, 10 $\mu$m or more, 15 $\mu$m or more, or 20 $\mu$m or more, at a pH of 10.

More specifically, the D50 particle size of debris obtained when the polishing layer is conditioned for 10 minutes under the above conditions may be 15 $\mu$m to 35 $\mu$m, 15 $\mu$m to 30 $\mu$m, 15 $\mu$m to 25 $\mu$m, 15 $\mu$m to 24 $\mu$m, 15 $\mu$m to 23 $\mu$m, 15 $\mu$m to 22.3 $\mu$m, 15 $\mu$m to 22 $\mu$m, or 15 $\mu$m to 21 $\mu$m, at a pH of 10.

According to a specific embodiment, the D50 particle size of debris obtained during the conditioning of the polishing layer may be 25 $\mu$m or less at a pH of 5.5 and 22.3 $\mu$m or less at a pH of 10.

Within the above preferred range, it is possible to minimize the occurrence of defects and scratches during a CMP process while maintaining excellent physical properties and performance of the polishing pad.

In addition, in the polishing pad according to an embodiment, an aqueous solution of debris obtained therefrom may have a zeta potential within a specific range.

Fig. 4 shows a method of measuring the zeta potential of an aqueous solution of debris obtained from a polishing pad according to an embodiment. Referring to Fig. 4, a polishing pad is attached to the platen of a CMP polishing machine, the polishing layer is conditioned while deionized water is supplied, and the debris of the polishing layer formed after 10 minutes of conditioning is collected in the form of a solution mixed with deionized water. To ensure particle stability in the aqueous solution of debris, it is stored at room temperature for 24 hours to precipitate particles with a particle diameter of 20 $\mu$m or more. The supernatant located within 10 mm from the top surface of the solution is then taken as a sample. Thereafter, the pH of the sample is adjusted using an aqueous nitric acid solution or an aqueous potassium hydroxide solution, and the zeta potential of the sample is then measured using a zetasizer. The sample may contain debris at a concentration of 0.01% by weight.

As an example, the zeta potential of an aqueous solution containing debris obtained when the polishing layer is conditioned for 10 minutes under the above conditions at a concentration of 0.01% by weight may be -20 mV or more, -15 mV or more, -10 mV or more, -5 mV or more, 0 mV or more, 5 mV or more, or 10 mV or more, and 50 mV or less, 40 mV or less, 30 mV or less, 20 mV or less, 15 mV or less, or 10 mV or less, at a pH of 5.5.

The zeta potential may be measured using a zetasizer (e.g. Nano-ZS90, Malvern).

According to an embodiment, the zeta potential of an aqueous solution containing debris obtained when the polishing layer is conditioned for 10 minutes under the above conditions at a concentration of 0.01% by weight is -20 mV to 30 mV at a pH of 5.5.

Specifically, the zeta potential of an aqueous solution containing debris obtained when the polishing layer is conditioned for 10 minutes under the above conditions at a concentration of 0.01% by weight may be -15 mV to 25 mV, -10 mV to 25 mV, -10 mV to 20 mV, -10 mV to 15 mV, -5 mV to 30 mV, or 0 mV to 30 mV, at a pH of 5.5.

More specifically, the zeta potential of the aqueous solution of debris may be a positive value (+).

Within the above preferred ranges, the zeta potential of debris is similar to the zeta potential of polishing particles (e.g., ceria particles) in a CMP polishing composition (slurry); thus, the occurrence of defects can be further reduced. Specifically, zeta potential is a quantitative representation of the size of repulsion and attraction between particles caused by positive and negative ions of the particles in a suspension. If the zeta potential of debris and that of polishing particles are similar, the repulsion between the particles increases, which prevents agglomeration thereof; thus, the occurrence of defects and scratches can be reduced by reducing the particle size in the composition.

As another example, the zeta potential of an aqueous solution containing debris obtained when the polishing layer is conditioned for 10 minutes under the above conditions at a concentration of 0.01% by weight may be -50 mV or more, -45 mV or more, -40 mV or more, -35 mV or more, or -30 mV or more, and 30 mV or less, 20 mV or less, 10 mV or less, 0 mV or less, -10 mV or less, or -20 mV or less, at a pH of 10.

Specifically, the zeta potential of an aqueous solution containing debris obtained when the polishing layer is conditioned for 10 minutes under the above conditions at a concentration of 0.01% by weight may be -50 mV to -10 mV at a pH of 10.

More specifically, the zeta potential of an aqueous solution containing debris obtained when the polishing layer is conditioned for 10 minutes under the above conditions at a concentration of 0.01% by weight may be -50 mV to -15 mV, -50 mV to -20 mV, -50 mV to -25 mV, -40 mV to -10 mV, or -30 mV to -10 mV, at a pH of 10.

In addition, as the polishing pad has a certain relationship between the particle size of debris and the zeta potential according to pH conditions, it can further enhance the above effect.

According to an embodiment, the value of the following Equation (1) may be -20 $\mu$m/mV to 30 $\mu$m/mV. In a specific embodiment, it may be -10 $\mu$m/mV to 20 $\mu$m/mV.

$$ D50\ [5.5]\ /\ Zp\ [5.5]\ ...\ (1) $$

Here, D50 [5.5] is the D50 particle size ($\mu$m) of debris obtained during conditioning of the polishing layer at a pH of 5.5, and Zp [5.5] is the zeta potential (mV) of an aqueous solution containing debris obtained during conditioning of the polishing layer at a concentration of 0.01% by weight at a pH of 5.5.

For example, the value of Equation (1) may be -20 $\mu$m/mV or more, -10 $\mu$m/mV or more, -5 $\mu$m/mV or more, or 0 $\mu$m/mV or more, and 30 $\mu$m/mV or less, 20 $\mu$m/mV or less, 15 $\mu$m/mV or less, 10 $\mu$m/mV or less, or 5 $\mu$m/mV or less. Specifically, the value of Equation (1) may be -10 $\mu$m/mV to 15 $\mu$m/mV, -5 $\mu$m/mV to 20 $\mu$m/mV, -5 $\mu$m/mV to 15 $\mu$m/mV, 0 $\mu$m/mV to 15 $\mu$m/mV, -5 $\mu$m/mV to 10 $\mu$m/mV, 0 $\mu$m/mV to 10 $\mu$m/mV, -5 $\mu$m/mV to 5 $\mu$m/mV, or 0 $\mu$m/mV to 5 $\mu$m/mV.

According to another embodiment, the value of the following Equation (2) may be 60% to 120%. In a specific embodiment, it may be 70% to 110%.

$$(D50\ [5.5]\ /\ D50\ [10]) \times 100 \ ... \ (2)$$

Here, D50 [5.5] is the D50 particle size ($\mu$m) of debris obtained during conditioning of the polishing layer at a pH of 5.5, and D50 [10] is the D50 particle size ($\mu$m) of debris obtained during conditioning of the polishing layer at a pH of 10.

For example, the value of Equation (2) may be 60% or more, 70% or more, or 75% or more, and 120% or less, 110% or less, 105% or less, 100% or less, 95% or less, 90% or less, 85% or less, or 80% or less. Specifically, the value of Equation (2) may be 70% to 105%, 70% to 100%, 70% to 95%, 70% to 90%, 70% to 85%, or 75% to 85%.

According to another embodiment, the value of the following Equation (3) may be 25 mV to 65 mV. In a specific embodiment, it may be 35.5 mV to 60 mV.

$$Zp\ [5.5] - Zp\ [10] \ ... \ (3)$$

Here, Zp [5.5] is the zeta potential (mV) of an aqueous solution containing debris obtained during conditioning of the polishing layer at a concentration of 0.01% by weight at a pH of 5.5, and Zp [10] is the zeta potential (mV) of an aqueous solution containing debris obtained during conditioning of the polishing layer at a concentration of 0.01% by weight at a pH of 10.

For example, the value of Equation (3) may be 25 mV or more, 35.5 mV or more, or 36 mV or more, and 65 mV or less, 60 mV or less, 55 mV or less, 50 mV or less, or 45 mV or less. Specifically, the value of Equation (3) may be 35.5 mV to 55 mV, 35.5 mV to 50 mV, 35.5 mV to 45 mV, 35.5 mV to 40 mV, 36 mV to 60 mV, 36 mV to 50 mV, 36 mV to 45 mV, or 36 mV to 40 mV.

In addition, the polishing pad according to an embodiment has excellent performance and overall physical properties.

For example, when the silicon oxide layer of a silicon wafer is polished with a ceria slurry using the polishing pad, the polishing rate (removal rate) may be 2,000 Å/minute or more, 2,200 Å/minute or more, 2,300 Å/minute or more, or 2,400 Å/minute or more, and 3,000 Å/minute or less, 2,800 Å/minute or less, 2,600 Å/minute or less, or 2,500 Å/minute or less.

As a specific example, when the silicon oxide layer of a silicon wafer is polished with a ceria slurry using the polishing pad, the polishing rate according to the following Mathematical Equation 1 may be 2,200 Å/minute to 2,600 Å/minute.

Polishing rate (Å/minute) = difference in thickness before and after polishing (Å) / polishing time (minute)                     [mathematical equation 1]

Specifically, the polishing rate may be a polishing rate for a silicon wafer having a diameter of 300 mm on which silicon oxide has been deposited. In addition, the polishing rate may be measured under a polishing load of 4.0 psi while the polishing pad is rotated at a speed of 150 rpm, a calcined ceria slurry is supplied onto the polishing pad at a rate of 250 ml/minute, and the platen is rotated at a speed of 150 rpm for 60 seconds. The temperature condition when the polishing rate is measured is not particularly limited, but it may be, for example, a room temperature condition.

In addition, the pad cut rate of the polishing layer may be 30 $\mu$m/hr to 60 $\mu$m/hr, 30 $\mu$m/hr to 50 $\mu$m/hr, 40 $\mu$m/hr to 60 $\mu$m/hr, or 40 $\mu$m/hr to 50 $\mu$m/hr.

The thickness of the polishing pad may be 0.8 mm to 5.0 mm, 1.0 mm to 4.0 mm, 1.0 mm to 3.0 mm, 1.5 mm to 2.5 mm, 1.7 mm to 2.3 mm, or 2.0 mm to 2.1 mm. Within the above range, the basic physical properties of a polishing pad can be sufficiently exhibited while the particle size variation between the upper and lower portions is minimized.

**Characteristics of the polishing pad when irradiated with UV light**

The polishing pad according to an embodiment has the feature of a reduced particle size of debris as UV light is irradiated during a CMP process. Thus, it is possible to minimize the occurrence of defects and scratches in semiconductor devices by irradiating UV light during a CMP process using these characteristics of the polishing pad.

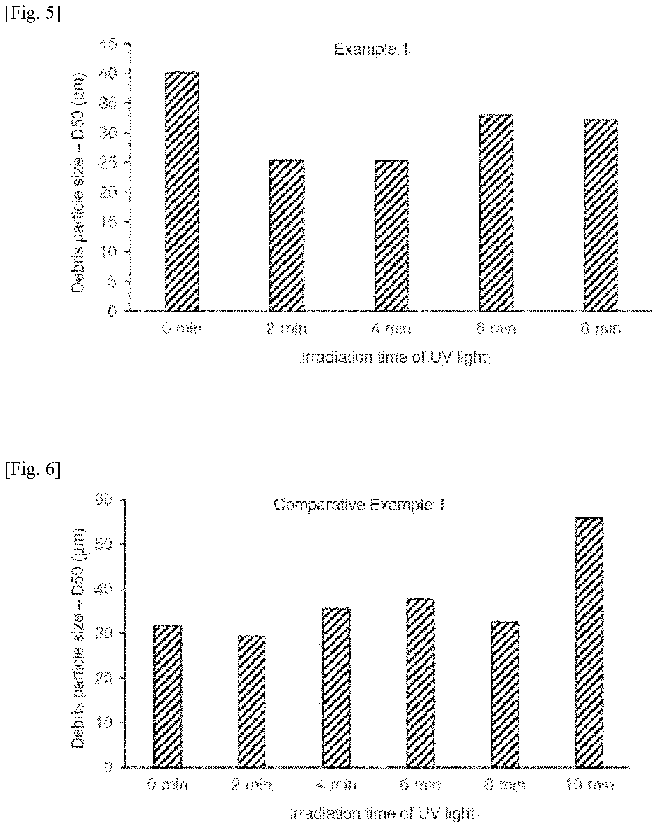

Figs. 5 and 6 each show the change in particle size of debris obtained from polishing pads according to the Examples and Comparative Examples with respect to irradiation time with UV.

Referring to Fig. 5, for the polishing pad according to an embodiment, the particle size of debris decreased as the irradiation time with UV light elapsed, which was measured to be the smallest at 2 to 4 minutes. Thereafter, a trend of slight increase was shown when the irradiation time with UV light further elapsed to 6 to 8 minutes. Overall, the debris particle size tended to decrease as the irradiation time with UV light elapsed. On the other hand, the polishing pad according to the Comparative Example showed a tendency for the particle size of debris to generally increase as the irradiation time with UV light elapsed. It was measured to be increased almost twice when 10 minutes elapsed as compared with the initial stage.

When irradiated with UV, molecular bonds are broken, and particles agglomerate at the same time. It is assumed that the particle size of debris tends to increase or decrease depending on which of these is dominant. This tendency may appear depending on the composition and characteristics of a polishing pad.

To measure the particle size of debris, a polishing pad is attached to the platen of a CMP polishing machine, the polishing layer is conditioned while a CMP slurry is supplied, and the debris of the polishing layer formed after 10 minutes of conditioning is collected in the form of a solution mixed with the CMP slurry. Thereafter, the debris solution is irradiated with UV light with a wavelength of 100 nm to 380 nm at an intensity of 1 kW from an appropriate distance, and the particle size of the debris is then measured using a particle size analyzer.

Specifically, the debris may be obtained during the conditioning of the polishing layer of the polishing pad while supplying 250 ml/minute of a ceria slurry under the conditions of a platen speed of 93 rpm, a conditioner load of 9 lbs, a conditioner speed of 64 rpm, and a sweep of 19 times/minute. The particle size of the debris may be an average particle size, i.e., a D50 particle size. As a specific example, a diamond disk (e.g., CI45 type disk from Saesol) with a pad wear rate (PWR) of 80 $\mu$m/hr to 90 $\mu$m/hr may be used in the conditioner.

In the polishing pad according to an embodiment, when the polishing layer is conditioned while a ceria slurry is supplied at 250 ml/minute under the conditions of a platen speed of 93 rpm, a conditioner load of 9 lbs, a conditioner speed of 64 rpm, and a sweep of 19 times/minute, followed by irradiation with UV light with a wavelength of 100 nm to 380 nm at an intensity of 1 kW from a distance of 5 cm, the debris obtained satisfies the following Relationship (1).

$$D50 \; [0 \; min] > D50 \; [4 \; min] \; ... \; (1)$$

Here, D50 [0 min] is the D50 particle size of the debris obtained in the conditioning before the irradiation with UV light, and D50 [4 min] is the D50 particle size of the debris obtained upon the irradiation with UV light for 4 minutes after the conditioning.

In particular, the difference between D50 [0 min] and D50 [4 min] in Relationship (1) may be a certain level or more. For example, when $\Delta$D50 [0-4 min] calculated according to the following equation is 5 $\mu$m or more, it is more advantageous in terms of the debris reduction effect owing to UV irradiation.

$$\Delta D50 \; [0\text{-}4 \; min] = D50 \; [0 \; min] - D50 \; [4 \; min]$$

Here, D50 [0 min] is the D50 particle size of the debris obtained in the conditioning before the irradiation with UV light, and D50 [4 min] is the D50 particle size of the debris obtained upon the irradiation with UV light for 4 minutes after the conditioning.

Specifically, $\Delta$D50 [0-4 min] may be 5 $\mu$m or more, 7 $\mu$m or more, 10 $\mu$m or more, or 13 $\mu$m or more, and 35 $\mu$m or less, 30 $\mu$m or less, 25 $\mu$m or less, or 20 $\mu$m or less. More specifically, $\Delta$D50 [0-4 min] may be 5 $\mu$m to 30 $\mu$m, 5 $\mu$m to 25 $\mu$m, 10 $\mu$m to 30 $\mu$m, or 10 $\mu$m to 25 $\mu$m.

D50 [4 min] may be, for example, 40 $\mu$m or less, 35 $\mu$m or less, 30 $\mu$m or less, 27 $\mu$m or less, or 25 $\mu$m or less, and 5 $\mu$m or more, 10 $\mu$m or more, 15 $\mu$m or more, or 20 $\mu$m or more. As a specific example, D50 [4 min] may be 30 $\mu$m or less. As a more specific example, D50 [4 min] may be 5 $\mu$m to 30 $\mu$m. Within the above preferred range, the occurrence of defects in semiconductor devices due to debris can be further minimized.

D50 [0 min] may be, for example, 20 $\mu$m or more, 25 $\mu$m or more, 30 $\mu$m or more, or 35 $\mu$m or more, and 65 $\mu$m or less, 60 $\mu$m or less, 55 $\mu$m or less, or 45 $\mu$m or less. Specifically, D50 [0 min] may be 20 $\mu$m to 60 $\mu$m or 30 $\mu$m to 50 $\mu$m.

More specifically, D50 [0 min] may be 35 $\mu$m or more, and D50 [4 min] may be 30 $\mu$m or less.

According to another embodiment, the polishing pad may satisfy the following Relationship 2:

$$D50 \; [4 \; min] < D50 \; [8 \; min] \; ... \; (2)$$

Here, D50 [4 min] is the D50 particle size of the debris obtained upon the irradiation with UV light for 4 minutes after the conditioning, and D50 [8 min] is the D50 particle size of the debris obtained upon the irradiation with UV light for 8 minutes after the conditioning.

Here, the difference between D50 [8 min] and D50 [4 min] in Relationship (2) may be a certain level or less. For example, when $\Delta$D50 [8-4 min] calculated according to the following equation is 20 $\mu$m or less, it is more advantageous for maintaining the trend of particle size reduction of debris due to UV irradiation.

$$\Delta D50 \; [8\text{-}4 \; min] = D50 \; [8 \; min] - D50 \; [4 \; min]$$

Here, D50 [4 min] is the D50 particle size of the debris obtained upon the irradiation with UV light for 4 minutes after the conditioning, and D50 [8 min] is the D50 particle size of the debris obtained upon the irradiation with UV light for 8 minutes after the conditioning.

Specifically, ΔD50 [8-4 min] may be 20 μm or less, 15 μm or less, or 10 μm or less, and 3 μm or more or 5 μm or more. More specifically, ΔD50 [8-4 min] may be 3 μm to 20 μm, 3 μm to 15 μm, 3 μm to 10 μm, or 5 μm to 15 μm.

D50 [8 min] may be, for example, 55 μm or less, 50 μm or less, 45 μm or less, or 40 μm or less, and 15 μm or more, 20 μm or more, 25 μm or more, or 30 μm or more. Specifically, D50 [8 min] may be 20 μm to 50 μm or 25 μm to 40 μm.

More specifically, D50 [8 min] may be 30 μm to 40 μm, and D50 [4 min] may be 20 μm to 30 μm.

According to another embodiment, the polishing pad may satisfy the following Relationship 3:

$$(D90\,[0\ min] - D10\,[0\ min]) > (D90\,[4\ min] - D10\,[4\ min]) \ ... \ (3)$$

Here, D10 [0 min] and D90 [0 min] are each the D10 and D90 particle sizes of the debris obtained in the conditioning before the irradiation with UV light, and D 10 [4 min] and D90 [4 min] are each the D10 and D90 particle sizes of the debris obtained upon the irradiation with UV light for 4 minutes after the conditioning.

The difference between (D90 [0 min] - D10 [0 min]) and (D90 [4 min] - D10 [4 min]) in Relationship (3) may be a certain level or more.

For example, when ΔD90-10 [4 min] calculated according to the following equation is 50 μm or more, it is more advantageous in terms of the debris particle size reduction effect owing to UV irradiation.

$$\Delta D90\text{-}10\,[4\ min] = (D90\,[0\ min] - D10\,[0\ min]) - (D90\,[4\ min] - D10\,[4\ min])$$

Here, D10 [0 min] and D90 [0 min] are each the D10 and D90 particle sizes of the debris obtained in the conditioning before the irradiation with UV light, and D10 [4 min] and D90 [4 min] are each the D10 and D90 particle sizes of the debris obtained upon the irradiation with UV light for 4 minutes after the conditioning.

Specifically, ΔD90-10 [4 min] may be 50 μm or more, 70 μm or more, 100 μm or more, or 120 μm or more, and 300 μm or less, 250 μm or less, 200 μm or less, or 150 μm or less. More specifically, ΔD90-10 [4 min] may be 50 μm to 300 μm, 100 μm to 200 μm, or 100 μm to 150 μm.

(D90 [0 min] - D10 [0 min]) in Relationship (3) may be 80 μm or more, 100 μm or more, 120 μm or more, or 140 μm or more, and 220 μm or less, 200 μm or less, or 180 μm or less. Specifically, (D90 [0 min] - D10 [0 min]) may be 100 μm to 200 μm or 140 μm to 180 μm.

(D90 [4 min] - D10 [4 min]) in Relationship (3) may be 10 μm or more, 20 μm or more, or 30 μm or more, and 80 μm or less, 70 μm or less, 60 μm or less, or 50 μm or less. Specifically, (D90 [4 min] - D10 [4 min]) may be 20 μm to 60 μm or 30 μm to 50 μm.

In addition, the polishing pad according to an embodiment is excellent in overall physical properties.

For example, when the silicon oxide layer of a silicon wafer is polished with a ceria slurry using the polishing pad, while irradiated with UV light with a wavelength of 100 nm to 380 nm at an intensity of 1 kW from a distance of 5 cm, the polishing rate (removal rate) may be 1,700Å/minute or more, 1,800Å/minute or more, 1,900Å/minute or more, or 2,000Å/minute or more, and 2,600Å/minute or less, 2,400Å/minute or less, 2,300Å/minute or less, 2,200Å/minute or less, or 2,100Å/minute or less.

As a specific example, when the silicon oxide layer of a silicon wafer is polished with a ceria slurry using the polishing pad, while irradiated with UV light with a wavelength of 100 nm to 380 nm at an intensity of 1 kW from a distance of 5 cm, the polishing rate according to the following Mathematical Equation 1 may be 1,800 Å/minute to 2,200 Å/minute.

Polishing rate (Å/minute) = difference in thickness before and after polishing (Å) / polishing time (minute)    [mathematical eqaution 1]

Specifically, the polishing rate may be a polishing rate for a silicon wafer having a diameter of 300 mm on which silicon oxide has been deposited. In addition, the polishing rate may be measured under a polishing load of 4.0 psi while the polishing pad is rotated at a speed of 150 rpm, a calcined ceria slurry is supplied onto the polishing pad at a rate of 250 ml/minute, and the platen is rotated at a speed of 150 rpm for 60 seconds. The temperature condition when the polishing rate is measured is not particularly limited, but it may be, for example, a room temperature condition.

In addition, when the polishing pad is tested at a conditioning pressure of 6 lbf and a rotation speed of 100 to 110 rpm, the pad wear rate (PWR) may be 15 μm/hr to 40 μm/hr. Specifically, the pad wear rate of the polishing layer may be 15 μm/hr to 35 μm/hr, 15 μm/hr to 30 μm/hr, 20 μm/hr to 40 μm/hr, or 15 μm/hr to 22 μm/hr.

The pad wear rate may be measured by pre-conditioning the polishing pad with deionized water for 10 minutes in the initial stage and then conditioning while deionized water was sprayed for 1 hour. In such an event, the changes in thickness may be measured during conditioning for 1 hour. The equipment used for conditioning may be AP-300HM of CTS. The conditioning pressure may be 6 lbf, the rotation speed may be 100 to 110 rpm, and the disk used for conditioning may be CI-45 of Sasol.

The thickness of the polishing pad may be 0.8 mm to 5.0 mm, 1.0 mm to 4.0 mm, 1.0 mm to 3.0 mm, 1.5 mm to 2.5 mm, 1.7 mm to 2.3 mm, or 2.0 mm to 2.1 mm. Within the above range, the basic physical properties of a polishing pad can be sufficiently exhibited while the particle size variation between the upper and lower portions is minimized.

Polishing layer

The polishing layer provides a polishing surface that is in contact with a semiconductor substrate in a CMP process and constitutes a top pad in the polishing pad.

The polishing layer according to an embodiment comprises a polyurethane resin.

The polishing layer comprises a urethane-based prepolymer, a foaming agent, and a curing agent. Specifically, the polyurethane resin may be formed from a composition that comprises a urethane-based prepolymer, a foaming agent, and a curing agent.

Specifically, the polishing layer comprises a polyurethane-based resin, which is a reaction product of a urethane-based prepolymer, a foaming agent, and a curing agent, i.e., a cured product of a composition in which the components are mixed. More specifically, it comprises a porous polyurethane-based resin. In addition, the polishing layer may comprise a plurality of pores formed from the foaming agent.

The polishing layer may have a thickness of, for example, 0.8 mm or more, 1 mm or more, 1.2 mm or more, or 1.5 mm or more, and 5 mm or less, 3 mm or less, 2.5 mm or less, or 2 mm or less. As a specific example, the thickness of the polishing layer may be 0.8 mm to 5 mm or 1.5 mm to 3 mm.

The polishing layer may have a specific gravity of, for example, 0.6 g/cm$^3$ or more, 0.7 g/cm$^3$ or more, or 0.75 g/cm$^3$ or more, and 0.9 g/cm$^3$ or less, 0.85 g/cm$^3$ or less, or 0.8 g/cm$^3$ or less. As a specific example, the specific gravity of the polishing layer may be 0.6 g/cm$^3$ to 0.9 g/cm$^3$ or 0.7 g/cm$^3$ to 0.9 g/cm$^3$. The specific gravity may be measured using a gravimeter.

The polishing layer may have a hardness of, for example, 30 Shore D or more, 40 Shore D or more, or 50 Shore D or more, and 80 Shore D or less, 70 Shore D or less, 65 Shore D or less, or 60 Shore D or less. As a specific example, the hardness of the polishing layer may be 30 Shore D to 80 Shore D or 50 Shore D to 65 Shore D. The hardness may be measured using a hardness tester.

The polishing layer may have a tensile strength of, for example, 5 N/mm$^2$ or more, 10 N/mm$^2$ or more, or 15 N/mm$^2$ or more, and 30 N/mm$^2$ or less, 25 N/mm$^2$ or less, or 20 N/mm$^2$ or less. As a specific example, the tensile strength of the polishing layer may be 5 N/mm$^2$ to 30 N/mm$^2$ or 15 N/mm$^2$ to 25 N/mm$^2$. The tensile strength may be measured as the tensile strength immediately before fracture which is measured while the sample is tested at a rate of 50 mm/minute using a universal testing machine (UTM).

The polishing layer may have an elongation of, for example, 50% or more, 70% or more, 90% or more, 106% or more, or 120% or more, and 300% or less, 250% or less, 200% or less, or 150% or less. As a specific example, the elongation of the polishing layer may be 50% to 300% or 90% to 130%. The elongation may be an elongation at break. The elongation may be the maximum deformation immediately before fracture which is measured while the sample is tested at a rate of 50 mm/min using a universal testing machine (UTM). The ratio of the maximum deformation to the initial length is expressed in percent (%).

As a specific example, the polishing layer may have a hardness of 50 Shore D to 65 Shore D, a tensile strength of 15 N/mm$^2$ to 25 N/mm$^2$, and an elongation of 90% to 130%.

The pores are present as dispersed in the polishing layer.

The average diameter of the pores may be, for example, 10 $\mu$m to 60 $\mu$m, 10 $\mu$m to 50 $\mu$m, 20 $\mu$m to 50 $\mu$m, 20 $\mu$m to 40 $\mu$m, 10 $\mu$m to 30 $\mu$m, 20 $\mu$m to 25 $\mu$m, or 30 $\mu$m to 50 $\mu$m.

In addition, the total area of the pores may be 30% to 60%, 35% to 50%, or 35% to 43%, based on the total area of the polishing layer. In addition, the total volume of the pores may be 30 to 70%, or 40 to 60%, based on the total volume of the polishing layer.

The polishing layer may have grooves on its surface for mechanical polishing. The grooves may have a depth, a width, and a spacing as desired for mechanical polishing, which is not particularly limited.

In the polishing pad according to an embodiment, the polishing layer has a content of chlorine (Cl) of 10,000 ppm or less when analyzed according to the IEC 62321-3-2 standard.

Specifically, the chlorine content may be obtained by measuring the content of chlorine in a sample by IEC 62321-3-2, which is an international standard for measuring specific substances in a polymer by combustion-ion chromatography (C-IC). In such an event, the sample to be measured for the chlorine content may be a circular sample taken in a size of 3 cm in diameter and 0.3 cm in height from the polishing layer of the polishing pad.

The IEC 62321-3-2 standard is a test method for screening halogen components developed in response to regulations for halogen use. The test method has excellent precision/accuracy and reproducibility as compared with conventional halogen analysis methods (e.g., oxygen bomb-IC and oxygen flask-IC) and is automated; thus, the reliability of the test results is excellent.

In a method for measuring the content of chlorine in the polishing pad according to an embodiment, a sample containing an organic chlorine (C-Cl) component is charged to a combustion tube and combusted by an electric furnace. The resultant material is transferred to an adsorption tube to measure the amount of chlorine ions (Cl$^-$) by ion chromatography.

In the polishing pad according to an embodiment, the content of chlorine in the polishing layer may be 10,000 ppm or less, for example, 5,000 ppm or less, 1,000 ppm or less, 500 ppm or less, 200 ppm or less, 100 ppm or less, 80 ppm or less, or 50 ppm or less. As the content of chlorine is adjusted to the above range, it is possible to reduce the size of debris while maintaining excellent physical properties and performance of the polishing pad, thereby minimizing the occurrence of defects and scratches during a CMP process.

In addition, the lower limit of the content range of chlorine in the polishing layer according to an embodiment may be, for example, 0 ppm or more, greater than 0 ppm, 1 ppm or more, 5 ppm or more, 10 ppm or more, 20 ppm or more, 50 ppm or more, or 100 ppm or more. Within the above preferred range, the surface area and adsorption force can be adjusted as the debris agglomerates into an appropriate size to facilitate adsorption and desorption in the wafer and pad, and the electrical attraction/repulsion force can be adjusted to make the polishing performance more appropriate.

As a specific example, the polishing layer has a content of chlorine (Cl) of 10 ppm to 1,000 ppm when analyzed according to the IEC 62321-3-2 standard. As another specific example, the polishing layer has a content of chlorine (Cl) of 10 ppm to 100 ppm, 20 ppm to 80 ppm, or 20 ppm to 50 ppm, when analyzed according to the IEC 62321-3-2 standard. As another specific example, the polishing layer has a content of chlorine (Cl) of 50 ppm to 10,000 ppm or 100 ppm to 10,000 ppm, when analyzed according to the IEC 62321-3-2 standard.

As the polishing pad according to an embodiment has a content of chlorine adjusted to a certain range as described above, it is possible to reduce the size of debris, thereby minimizing the occurrence of defects and scratches during a CMP process.

**Urethane-based prepolymer**

The polishing pad according to an embodiment comprises a urethane-based prepolymer.

A prepolymer generally refers to a polymer having a relatively low molecular weight wherein the degree of polymerization is adjusted to an intermediate level so as to conveniently mold a molded article in the process of producing a cured product. A prepolymer may be molded to a final cured product by itself or after a reaction with another polymerizable compound.

In an embodiment, the urethane-based prepolymer may be prepared by reacting an isocyanate compound with a polyol.

The isocyanate compound used in the preparation of the urethane-based prepolymer may be one selected from the group consisting of an aromatic diisocyanate, an aliphatic diisocyanate, an alicyclic diisocyanate, or combinations thereof.

The isocyanate compound may comprise, for example, one selected from the group consisting of toluene 2,4-diisocyanate (2,4-TDI), toluene 2,6-diisocyanate (2,6-TDI), naphthalene 1,5-diisocyanate, para-phenylene diisocyanate, tolidine diisocyanate, 4,4'-diphenylmethane diisocyanate, hexamethylene diisocyanate, dicyclohexylmethane diisocyanate, isophorone diisocyanate, and combinations thereof.

The polyol is a compound comprising at least two or more hydroxyl groups (-OH) per molecule. For example, it may comprise one selected from the group consisting of a polyether polyol, a polyester polyol, a polycarbonate polyol, a polycaprolactone polyol, and combinations thereof.

The polyol may comprise, for example, one selected from the group consisting of polytetramethylene ether glycol, polypropylene ether glycol, ethylene glycol, 1,2-propylene glycol, 1,3-propylene glycol, 1,2-butanediol, 1,3-butanediol, 2-methyl-1,3-propanediol, 1,4-butanediol, neopentyl glycol, 1,5-pentanediol, 3-methyl-1,5-pentanediol, 1,6-hexanediol, diethylene glycol, dipropylene glycol, tripropylene glycol, and combinations thereof.

The polyol may have a weight average molecular weight (Mw) of 100 to 3,000. The polyol may have a weight average molecular weight (Mw) of, for example, 100 to 3,000, for example, 100 to 2,000, for example, 100 to 1,800.

In an embodiment, the polyol may comprise a low molecular weight polyol having a weight average molecular weight (Mw) of 100 to 300 and a high molecular weight polyol having a weight average molecular weight (Mw) of 300 to 1,800.

The urethane-based prepolymer may have a weight average molecular weight (Mw) of 500 to 3,000. The urethane-based prepolymer may have a weight average molecular weight (Mw) of, for example, 1,000 to 2,000 or, for example, 1,000 to 1,500.

In an embodiment, the isocyanate compound for the preparation of the urethane-based prepolymer may comprise an aromatic diisocyanate compound, and the aromatic diisocyanate compound, for example, may comprise 2,4-toluene diisocyanate (2,4-TDI) and 2,6-toluene diisocyanate (2,6-TDI). The polyol compound for the preparation of the urethane-based prepolymer may comprise polytetramethylene ether glycol (PTMEG) and diethylene glycol (DEG).

In another embodiment, the isocyanate compound for the preparation of the urethane-based prepolymer may comprise an aromatic diisocyanate compound and a cycloaliphatic diisocyanate compound. For example, the aromatic diisocyanate compound comprises 2,4-toluene diisocyanate (2,4-TDI) and 2,6-toluene diisocyanate (2,6-TDI), and the cycloaliphatic diisocyanate compound comprises dicyclohexylmethane diisocyanate (H12MDI). The polyol compound for the preparation of the urethane-based prepolymer may comprise polytetramethylene ether glycol (PTMEG) and diethylene glycol (DEG).

The urethane-based prepolymer may have an isocyanate end group content (NCO%) of 5% by weight or more, 8% by weight or more, or 10% by weight or more, and 13% by weight or less, 12% by weight or less, or 11% by weight or less. As a specific example, the urethane-based prepolymer may have an isocyanate end group content (NCO%) of 10% by weight to 11% by weight.

The isocyanate end group content (NCO%) of the urethane-based prepolymer may be designed by comprehensively adjusting the type and content of the isocyanate compound and the polyol compound for the preparation of the urethane-based prepolymer, the process conditions such as temperature, pressure, and time in the process for preparing the urethane-based prepolymer, and the type and content of the additives used in the preparation of the urethane-based prepolymer.

If the isocyanate end group content (NCO%) of the urethane-based prepolymer satisfies the above range, the reaction rate, reaction time, and final curing structure in the subsequent reaction between the urethane-based prepolymer and a curing agent can be adjusted in a way favorable to the polishing performance from the viewpoint of the use and purpose of a final polishing pad.

In an embodiment, the urethane-based prepolymer may have an isocyanate end group content (NCO%) of 8% by weight to 10% by weight, for example, 8% by weight to 9.4% by weight. If the NCO% of the urethane-based prepolymer is less than the above range, the electrical properties based on the chemically hardened structure in the polishing pad may be achieved such that the desired polishing performance in terms of polishing rate and flatness are not achieved, and there may be a problem in that the lifespan of the polishing pad is reduced due to an excessive increase in the pad cut rate or cut wear rate. On the other hand, if the NCO% exceeds the above range, surface defects such as scratches and chatter marks on a semiconductor substrate may increase.

## Foaming agent

The foaming agent is a component for forming a pore structure in the polishing layer. It may comprise one selected from the group consisting of a solid phase foaming agent, a gas phase foaming agent, a liquid phase foaming agent, and combinations thereof.

According to an embodiment, the foaming agent may be a non-chlorine-based foaming agent that does not contain a chlorine component. In particular, it may not contain, or minimize, the use of a chlorine-based foaming agent component commonly used in the preparation of polishing pads, such as vinylidene chloride (VDC). For example, the content of the non-chlorine-based foaming agent may be 50% by weight or more, 80% by weight or more, 90% by weight or more, 95% by weight or more, 97% by weight or more, 99% by weight or more, or 99.5% by weight or more, and 100% by weight or less or 99.5% by weight or less, as a specific example, 80% by weight to 100% by weight, 90% by weight to 100% by weight, or 80% by weight to 99.5% by weight, based on the total weight of the foaming agent. In addition, the content of the chlorine-based foaming agent may be 20% by weight or less, 10% by weight or less, 5% by weight or less, 1% by weight or less, 0.5% by weight or less, or 0.3% by weight or less, and 0% by weight or more, 0.1% by weight or more, 0.5% by weight or more, as a specific example, 0% by weight to 20% by weight, 0% by weight to 1% by weight, 0% by weight to 0.5% by weight, or 0.5% by weight to 20% by weight, based on the total weight of the foaming agent.

The foaming agent may be at least one selected from a solid phase foaming agent comprising particles having a hollow structure, a liquid phase foaming agent using a volatile liquid, and an inert gas.

As an example, the solid phase foaming agent may comprise particles having a hollow structure that have been expanded by heat and adjusted in size. Such a solid phase foaming agent has the advantage of controlling the size of pores to be uniform as it is employed in the raw material in an already expanded form and has a uniform particle size.

In addition, the solid phase foaming agent may comprise expandable particles. The expandable particles are particles having a characteristic that can be expanded by heat or pressure. Their size in the final polishing layer may be determined by heat or pressure applied in the process of preparing the polishing layer. The expandable particles are employed in the raw material in a particle state that has not been already expanded. Their final size is determined when expanded by heat or pressure applied during the process of preparing the polishing layer.

The solid phase foaming agent may have an average particle size of 5 $\mu$m to 100 $\mu$m, specifically, 5 $\mu$m to 50 $\mu$m or 20 $\mu$m to 50 $\mu$m. The average particle size of the solid phase foaming agent may refer to the average particle size of expanded particles themselves when the solid phase foaming agent is particles employed in the raw material in an expanded state as described below. It may refer to the average particle diameter of particles after they are expanded by heat or pressure in the preparation process when the solid phase foaming agent is particles employed in the raw material in an unexpanded state as described below.

The solid phase foaming agent in the form of expandable particles may comprise a shell of a resin; and an expansion-inducing component encapsulated inside the shell. These expandable particles may be formed into a hollow structure by the vaporization of the encapsulated expansion-inducing component by heat during the preparation process.

For example, the shell may comprise a thermoplastic resin. The thermoplastic resin may be at least one selected from the group consisting of an acrylonitrile-based copolymer, a methacrylonitrile-based copolymer, and an acrylic copolymer.

The thickness of the shell may be, for example, 0.1 $\mu$m or more, 0.5 $\mu$m or more, 1 $\mu$m or more, 2 $\mu$m or more, or 3 $\mu$m or more, and 15 $\mu$m or less, 12 $\mu$m or less, or 10 $\mu$m or less, as a specific example, 2 $\mu$m to 15 $\mu$m.

The expansion-inducing component may comprise one selected from the group consisting of a hydrocarbon compound, a tetraalkylsilane compound, and combinations thereof. Specifically, the hydrocarbon may comprise one selected from the group consisting of ethane, ethylene, propane, propene, n-butane, isobutane, n-butene, isobutene, n-pentane, isopentane, neopentane, n-hexane, heptane, petroleum ether, and combinations thereof. The tetraalkylsilane compound may comprise one selected from the group consisting of tetramethylsilane, trimethylethylsilane, trimethylisopropylsilane, trimethyl-n-propylsilane, and combinations thereof.

The solid phase foaming agent may comprise particles treated with an inorganic component. In an embodiment, the solid phase foaming agent may be one treated with silica ($SiO_2$) particles. The treatment of the solid phase foaming agent with an inorganic component can prevent aggregation between a plurality of particles. The solid phase foaming agent treated with an inorganic component may be different from the solid phase foaming agent that is not treated with an inorganic component in terms of the chemical, electrical, and/or physical properties of the surface of the foaming agent.

The commercial products of the solid phase foaming agent include Nouryon's 920DE20d70, 051DET40d25, and 051DET40d42 and Matsumoto's F-65DE, F-80DE, and FN-80SDE.

As a specific example, the foaming agent used in the polishing pad according to an embodiment comprises a solid phase foaming agent. The solid phase foaming agent may comprise at least one selected from the group consisting of an acrylonitrile-based copolymer, a methylmethacrylate-based copolymer, a methacrylonitrile-based copolymer, and an acrylic-based copolymer.

The content of the solid phase foaming agent may be 0.1 part by weight or more, 0.5 part by weight or more, or 1 part by weight or more, and 5 parts by weight or less, 3 parts by weight or less, or 2 parts by weight or less, relative to 100 parts by weight of the urethane-based prepolymer. As a specific example, the content of the solid phase foaming agent may be 0.1 part by weight to 5 parts by weight or 0.5 part by weight to 2 parts by weight, relative to 100 parts by weight of the urethane-based prepolymer.

The type and content of the solid phase foaming agent may be designed according to the desired pore structure and physical properties of the polishing layer.

Meanwhile, the liquid phase foaming agent may be introduced during the mixing and reaction of the prepolymer and the curing agent to form pores. It does not participate in the reaction between the prepolymer and the curing agent. In addition, the liquid phase foaming agent is physically vaporized by heat generated during the mixing and reaction of the prepolymer and the curing agents to form pores.

The volatile liquid phase foaming agent may be liquid at 25°C while it does not react with an isocyanate group, an amide group, and an alcohol group. Specifically, the volatile liquid phase foaming agent may be selected from the group consisting of cyclopentane, n-pentane, cyclohexane, n-butyl acetate, bis(nonafluorobutyl)(trifluoromethyl)amine; and perfluoro compounds such as perfluorotributylamine, perfluoro-N-methylmorpholine, perfluorotripentylamine, and perfluorohexane. Commercially available products of the perfluoro compound include FC-40 (3M), FC-43 (3M), FC-70 (3M), FC-72 (3M), FC-770 (3M), FC-3283 (3M), and FC-3284 (3M).

In addition, the foaming agent may comprise a gas phase foaming agent. For example, the foaming agent may comprise a solid phase foaming agent and a gas phase foaming agent.

The gas phase foaming agent may comprise an inert gas. The gas phase foaming agent is fed while the urethane-based prepolymer and the curing agent are reacted in order to be used as a component to form pores.

The kind of the inert gas is not particularly limited as long as it is a gas that does not participate in the reaction between the urethane-based prepolymer and the curing agent. For example, the inert gas may comprise one selected from the group consisting of nitrogen gas ($N_2$), carbon dioxide gas ($CO_2$), argon gas (Ar), helium gas (He), and combinations thereof.

The type and content of the gas phase foaming agent may be designed according to the desired pore structure and physical properties of the polishing layer.

The inert gas may be fed in a volume of 10% to 30% based on the total volume of the composition. Specifically, the inert gas may be fed in a volume of 15% to 30% based on the total volume of the composition. Specifically, the gas phase foaming agent may be fed through a predetermined feeding line while the urethane-based prepolymer, the solid phase foaming agent, and the curing agent are mixed. The feeding rate of the gas phase foaming agent is about 0.8 L/minute to about 2.0 L/minute, for example, about 0.8 L minute to about 1.8 L/minute, for example, about 0.8 L/minute to about 1.7 L/minute, for example, about 1.0 L/minute to about 2.0 L/minute, for example, about 1.0 L/minute to about 1.8 L/minute, for example, about 1.0 L/minute to about 1.7 L/minute.

**Curing agent**

The curing agent is a compound for chemically reacting with the urethane-based prepolymer to form a final cured structure in the polishing layer. For example, it may comprise an amine compound or an alcohol compound. Specifically, the curing agent may comprise one selected from the group consisting of an aromatic amine, an aliphatic amine, an aromatic alcohol, an aliphatic alcohol, and combinations thereof.

According to an embodiment, the curing agent may comprise a non-chlorine-based curing agent that does not contain a chlorine component. For example, the content of the non-chlorine-based curing agent may be 50% by weight or more, 80% by weight or more, 90% by weight or more, 95% by weight or more, 97% by weight or more, 99% by weight or more, or 99.5% by weight or more, and 100% by weight or less or 99.5% by weight or less, as a specific example, 80% by weight to 100% by weight, 90% by weight to 100% by weight, or 80% by weight to 99.5% by weight, based on the total weight of the curing agent. In addition, the content of the chlorine-based curing agent may be 20% by weight or less, 10% by weight or less, 5% by weight or less, 1% by weight or less, 0.5% by weight or less, or 0.3% by weight or less, and 0% by weight or more, 0.1% by weight or more, 0.5% by weight or more, as a specific example, 0% by weight to 20% by weight, 0% by weight to 1% by weight, 0% by weight to 0.5% by weight, or 0.5% by weight to 20% by weight, based on the total weight of the curing agent.

The curing agent may be at least one selected from a solid phase curing agent and a liquid phase curing agent.

The solid phase curing agent may contain an active hydrogen group. The solid phase curing agent may contain an amine group ($-NH_2$) as an active hydrogen group.

In addition, the solid phase curing agent may be an ester compound containing two or more benzene rings. Specifically, the solid phase curing agent may comprise two or more of the ester groups in the molecule.

The solid phase curing agent may have a weight average molecular weight of 150 to 400, for example, 150 to 350, for example, 200 to 350, for example, 250 to 350, for example, 300 to 350. The solid phase curing agent may have a melting point (m.p.) of 100°C to 150°C, for example, 100°C to 140°C, for example, 110°C to 130°C.

In an embodiment, the solid phase curing agent comprises at least one selected from the group consisting of 1,3-propanediol bis(4-aminobenzoate) (PDPAB), 4-(4-aminobenzoyl)oxyphenyl 4-aminobenzoate, 4-(4-aminobenzoyl)oxybutyl 4-aminobenzoate, 4-[4-(4-aminobenzoyl)oxy-3-methylbutoxy]butyl 4-aminobenzoate, and methylene bis-methylanthranilate (MBNA).

The liquid phase curing agent may contain an active hydrogen group. The liquid phase curing agent may contain at least one selected from the group consisting of an amine group ($-NH_2$), a hydroxyl group ($-OH$), a carboxylic acid group ($-COOH$), an epoxy group, and a combination thereof as an active hydrogen group. Specifically, it may contain an amine group ($-NH_2$).

In addition, the liquid phase curing agent may contain sulfur in the molecule. Specifically, it may contain two or more sulfur elements in the molecule.

The liquid phase curing agent may have a weight average molecular weight of 50 to 300, for example, 100 to 250, for example, 150 to 250, for example, 200 to 250.

In addition, the liquid phase curing agent may be liquid at room temperature. Alternatively, the liquid phase curing agent may have a boiling point (b.p.) of 160°C to 240°C, specifically 170°C to 240°C, more specifically 170°C to 220°C.

Examples of the liquid phase curing agent include at least one selected from the group consisting of 3,5-dimethylthio-2,6-diaminotoluene (DMTDA), 2,6-bis(methylthio)-4-methyl-1,3-benzenediamine, and N,N'-bis(sec-butylamino)diphenylmethane.

In addition, the curing agents may further comprise other curing agents in addition to the liquid phase curing agent and the solid phase curing agent. The additional curing agent may be, for example, at least one of an amine compound and an alcohol compound. Specifically, the additional curing agent may comprise at least one compound selected from the group consisting of an aromatic amine, an aliphatic amine, an aromatic alcohol, and an aliphatic alcohol.

For example, the additional curing agent may be at least one selected from the group consisting of diaminodiphenylmethane, diaminodiphenyl sulphone, m-xylylene diamine, isophoronediamine, ethylenediamine, diethylenetriamine, triethylenetetramine, polypropylenediamine, polypropylenetriamine, ethylene glycol, diethylene glycol, dipropylene glycol, butanediol, hexanediol, glycerin, and trimethylolpropane.

As a specific example, the curing agent may comprise at least one selected from the group consisting of diethyltoluenediamine (DETDA), 3,5-dimethylthio-2,6-diaminotoluene (DMTDA), 1,3-propanediol bis(4-aminobenzoate) (PDPAB), N,N'-bis(sec-butylamino)diphenylmethane, 2,6-bis(methylthio)-4-methyl-1,3-benzenediamine, 4-(4-aminobenzoyl)oxyphenyl 4-aminobenzoate, 4-(4-aminobenzoyl)oxybutyl 4-aminobenzoate, 4-[4-(4-aminobenzoyl)oxy-3-methylbutoxy]butyl 4-aminobenzoate, and methylene bis-methylanthranilate (MBNA).

The content of the curing agent may be 5 parts by weight or more, 10 parts by weight or more, 15 parts by weight or more, or 20 parts by weight or more, and 50 parts by weight or less, 45 parts by weight or less, 40 parts by weight or less, 35 parts by weight or less, 30 parts by weight or less, or 25 parts by weight or less, relative to 100 parts by weight of the urethane-based prepolymer. The content of the curing agent may be 10 parts by weight to 40 parts by weight, more specifically, 15 parts by weight to 35 parts by weight or 15 parts by weight to 25 parts by weight, relative to 100 parts by weight of the urethane-based prepolymer.

**Additives**

The composition for preparing a polishing layer may further comprise other additives such as a surfactant and a reaction rate controlling agent. The names such as "surfactant" and "reaction rate controlling agent" are arbitrary names based on the main role of the substances. The respective substances do not necessarily perform only a function limited to the role defined by the names.

The surfactant is not particularly limited as long as it acts to prevent pores from coalescing and overlapping with each other. For example, the surfactant may comprise a silicone-based surfactant.

The surfactant may be employed in an amount of 0.2 part by weight to 2 parts by weight relative to 100 parts by weight of the urethane-based prepolymer. Specifically, the surfactant may be employed in an amount of 0.2 part by weight to 1.9 parts by weight, for example, 0.2 part by weight to 1.8 parts by weight, for example, 0.2 part by weight to 1.7 parts by weight, for example, 0.2 part by weight to 1.6 parts by weight, for example, 0.2 part by weight to 1.5 parts, for example, 0.5 part by weight to 1.5 parts by weight, relative to 100 parts by weight of the urethane-based prepolymer. If the amount of the surfactant is within the above range, pores derived from the gas phase foaming agent can be stably formed and maintained in the mold.

The reaction rate controlling agent serves to promote or retard the reaction. A reaction promoter, a reaction retarder, or both may be used depending on the purpose. The reaction rate controlling agent may comprise a reaction promoter. For example, the reaction rate controlling agent may be at least one reaction promoter selected from the group consisting of a tertiary amine-based compound and an organometallic compound.

Specifically, the reaction rate controlling agent may comprise at least one selected from the group consisting of triethylenediamine, dimethylethanolamine, tetramethylbutanediamine, 2-methyl-triethylenediamine, dimethylcyclohexylamine, triethylamine, triisopropanolamine, 1,4-diazabicyclo(2,2,2)octane, bis(2-methylaminoethyl) ether, trimethylaminoethylethanolamine, N,N,N,N,N"-pentamethyldiethylenetriamine, dimethylaminoethylamine, dimethylaminopropylamine, benzyldimethylamine, N-ethylmorpholine, N,N-dimethylaminoethylmorpholine, N,N-dimethylcyclohexylamine, 2-methyl-2-azanorbornane, dibutyltin dilaurate, stannous octoate, dibutyltin diacetate, dioctyltin diacetate, dibutyltin maleate, dibutyltin di-2-ethylhexanoate, and dibutyltin dimercaptide. Specifically, the reaction rate controlling agent may comprise at least one selected from the group consisting of benzyldimethylamine, N,N-dimethylcyclohexylamine, and triethylamine.

The reaction rate controlling agent may be employed in an amount of 0.05 part by weight to 2 parts by weight relative to 100 parts by weight of the urethane-based prepolymer. Specifically, the reaction rate controlling agent may be employed in an amount of 0.05 part by weight to 1.8 parts by weight, for example, 0.05 part by weight to 1.7 parts by weight, for example, 0.05 part by weight to 1.6 parts by weight, for example, 0.1 part by weight to 1.5 parts by weight, for example, 0.1 part by weight to 0.3 part by weight, for example, 0.2 part by weight to 1.8 parts by weight, for example, 0.2 part by weight to 1.7 parts by weight, for example, 0.2 part by weight to 1.6 parts by weight, for example, 0.2 part by weight to 1.5 parts by weight, for example, 0.5 part by weight to 1 part by weight, relative to 100 parts by weight of the urethane-based prepolymer. If the reaction rate controlling agent is used in the above content range, the curing reaction rate of the prepolymer composition may be appropriately controlled to form a polishing layer having pores of a desired size and hardness.

**Support layer**

The support layer constitutes a sub pad and serves to support the polishing layer and to absorb and disperse an impact applied to the polishing layer. Thus, it minimizes damage and defects to the object to be polished during the polishing process using the polishing pad.

The support layer may comprise a nonwoven fabric or a suede, but it is not limited thereto.

In an embodiment, the support layer may be a resin-impregnated nonwoven fabric. The nonwoven fabric may be a fibrous nonwoven fabric comprising one selected from the group consisting of a polyester fiber, a polyamide fiber, a polypropylene fiber, a polyethylene fiber, and combinations thereof.

The resin impregnated in the nonwoven fabric may comprise a polyurethane resin, a polybutadiene resin, a styrene-butadiene copolymer resin, a styrene-butadiene-styrene copolymer resin, an acrylonitrile-butadiene copolymer resin, a styrene-ethylene-butadiene-styrene copolymer resin, a silicone rubber resin, a polyester-based elastomer resin, a polyamide-based elastomer resin, and combinations thereof.

The support layer may have a thickness of, for example, 0.3 mm or more or 0.5 mm or more, and 3 mm or less, 2 mm or less, or 1 mm or less. As a specific example, the thickness of the support layer may be 0.3 mm to 3 mm or 0.5 mm to 1 mm.

The support layer may have a hardness of, for example, 50 Asker C or more, 60 Asker C or more, or 70 Asker C or more, and 100 Asker C or less, 90 Asker C or less, or 80 Asker C or less. As a specific example, the hardness of the support layer may be 50 Asker C to 100 Asker C or 60 Asker C to 90 Asker C.

In addition, an adhesive layer may be interposed between the polishing layer (top pad) and the support layer (sub pad).

The adhesive layer may comprise a hot melt adhesive. The hot melt adhesive may be at least one selected from the group consisting of a polyurethane resin, a polyester resin, an ethylene-vinyl acetate resin, a polyamide resin, and a polyolefin resin. Specifically, the hot melt adhesive may be at least one selected from the group consisting of a polyurethane resin and a polyester resin.

In addition, a double-sided adhesive tape may be laminated under the support layer. When it is applied to CMP equipment, it is attached to the platen for use once the release paper of the double-sided adhesive tape has been removed.

**Process for preparing a polishing pad**

The process for preparing a polishing pad according to an embodiment comprises preparing a composition for a polishing pad comprising a urethane-based prepolymer, a foaming agent, and a curing agent; injecting the composition for a polishing pad into a mold and curing it to prepare a polishing layer; and laminating the polishing layer with a support layer.

The specific types and contents of the urethane-based prepolymer, curing agent, and foaming agent are as exemplified above.

As a specific example, the foaming agent comprises a solid phase foaming agent, the solid phase foaming agent comprises at least one selected from the group consisting of an acrylonitrile-based copolymer, a methyl methacrylate-based copolymer, a methacrylonitrile-based copolymer, and an acrylic-based copolymer, and the curing agent comprises at least one selected from the group consisting of diethyltoluenediamine (DETDA), 3,5-dimethylthio-2,6-diaminotoluene (DMTDA), 1,3-propanediol bis(4-aminobenzoate) (PDPAB), N,N'-bis(sec-butylamino)diphenylmethane, 2,6-bis(methylthio)-4-methyl-1,3-benzenediamine, 4-(4-aminobenzoyl)oxyphenyl 4-aminobenzoate, 4-(4-aminobenzoyl)oxybutyl 4-aminobenzoate, 4-[4-(4-aminobenzoyl)oxy-3-methylbutoxy]butyl 4-aminobenzoate, and methylene bis-methylanthranilate (MBNA).

The composition for a polishing pad may be prepared by sequentially or simultaneously mixing a urethane-based prepolymer, a foaming agent, and a curing agent.

As an example, the step of preparing the composition for a polishing pad may be carried out by mixing a urethane-based prepolymer with a curing agent, followed by further mixing with a foaming agent, or by mixing the urethane-based prepolymer with the foaming agent, followed by further mixing with the curing agent.

As another example, a urethane-based prepolymer, a curing agent, and a foaming agent may be put into the mixing process substantially at the same time. If a foaming agent, a surfactant, and an inert gas are further added, they may be put into the mixing process substantially at the same time.

As another example, a urethane-based prepolymer, a foaming agent, and a surfactant may be mixed in advance, and a curing agent, or a curing agent with an inert gas, may be subsequently introduced.

The mixing initiates the reaction of the urethane-based prepolymer and the curing agents and uniformly disperses the foaming agent and the inert gas in the raw materials. In such an event, a reaction rate controlling agent may intervene in the reaction between the urethane-based prepolymer and the curing agent from the beginning of the reaction, to thereby control the reaction rate. Specifically, the mixing may be carried out at a speed of 1,000 to 10,000 rpm or 4,000 to 7,000 rpm. Within the above speed range, it may be more advantageous for the inert gas and the foaming agent to be uniformly dispersed in the raw materials.

In addition, the step of preparing the composition for a polishing pad may be carried out under the condition of 50°C to 150°C. If necessary, it may be carried out under vacuum defoaming conditions.

If the foaming agent comprises a solid phase foaming agent, the step of preparing the composition for a polishing pad may comprise mixing the urethane-based prepolymer and the solid phase foaming agent to prepare a first preliminary composition; and mixing the first preliminary composition and the curing agent to prepare a second preliminary composition.

The first preliminary composition may have a viscosity of about 1,000 cps to about 2,000 cps, for example, about 1,000 cps to about 1,800 cps, for example, about 1,000 cps to about 1,600 cps, for example, about 1,000 cps to about 1,500 cps at about 80°C.

If the foaming agent comprises a gas phase foaming agent, the step of preparing the composition for a polishing pad may comprise preparing a third preliminary composition comprising the urethane-based prepolymer and the curing agent; and feeding the gas phase foaming agent to the third preliminary composition to prepare a fourth preliminary composition. In an embodiment, the third preliminary composition may further comprise a solid phase foaming agent.

In an embodiment, the step of preparing a polishing layer comprises preparing a mold preheated to a first temperature; and injecting the composition for a polishing pad into the preheated mold and curing it; and post-curing the cured composition for a polishing pad under a second temperature condition higher than the preheating temperature.

In an embodiment, the temperature difference between the first temperature and the second temperature may be about 10°C to about 40°C, for example, about 10°C to about 35°C, for example, about 15°C to about 35°C. In an embodiment, the first temperature may be about 60°C to about 100°C, for example, about 65°C to about 95°C, for example, about 70°C to about 90°C. In an embodiment, the second temperature may be about 100°C to about 130°C, for example, about 100°C to about 125°C, for example, about 100°C to about 120°C.

The step of curing the composition for a polishing pad at the first temperature may be carried out for about 5 minutes to about 60 minutes, for example, about 5 minutes to about 40 minutes, for example, about 5 minutes to about 30 minutes, for example, about 5 minutes to about 25 minutes.

The step of post-curing the composition for a polishing pad cured at the first temperature at the second temperature may be carried out for about 5 hours to about 30 hours, for example, about 5 hours to about 25 hours, for example, about 10 hours to about 30 hours, for example, about 10 hours to about 25 hours, for example, about 12 hours to about 24 hours, for example, about 15 hours to about 24 hours.

Thereafter, the step of injecting the composition for a polishing pad into a mold and curing it may be carried out under the temperature condition of 60°C to 120°C and the pressure condition of 50 kg/m$^2$ to 200 kg/m$^2$.

In addition, the above preparation process may further comprise the steps of cutting the surface of a polishing pad thus obtained, machining grooves on the surface thereof, bonding it with a lower part, inspection, packaging, and the like. These steps may be carried out in a conventional manner for preparing a polishing pad.

As an example, the process for preparing a polishing pad may further comprise machining at least one side of the polishing layer. The step of machining at least one side of the polishing layer may comprise forming grooves on at least one side of the polishing layer; line turning at least one side of the polishing layer; and roughening at least one side of the polishing layer.

The grooves may comprise at least one of concentric circular grooves spaced apart from the center of the polishing layer at a certain interval; and radial grooves continuously connected from the center of the polishing layer to the edge of the polishing layer. The line turning may be carried out by cutting the polishing layer in a certain thickness using a cutting tool. The roughening may be carried out by machining the surface of the polishing layer with a sanding roller.

**Process for preparing a semiconductor device**

A semiconductor device may be fabricated through chemical and mechanical polishing using the polishing pad described above.

The process for preparing a semiconductor device according to an embodiment comprises conditioning the polishing layer of the polishing pad with irradiation of UV light with a wavelength of 100 nm to 380 nm while chemically and mechanically polishing a semiconductor substrate using the polishing pad.

Specifically, the process for preparing a semiconductor device comprises relatively rotating the polishing layer of the polishing pad and the surface of a semiconductor substrate while they are in contact with each other to polish the surface of the semiconductor substrate. In addition, the process for preparing a semiconductor device comprises conditioning the polishing layer of the polishing pad with irradiation of UV light with a wavelength of 100 nm to 380 nm.

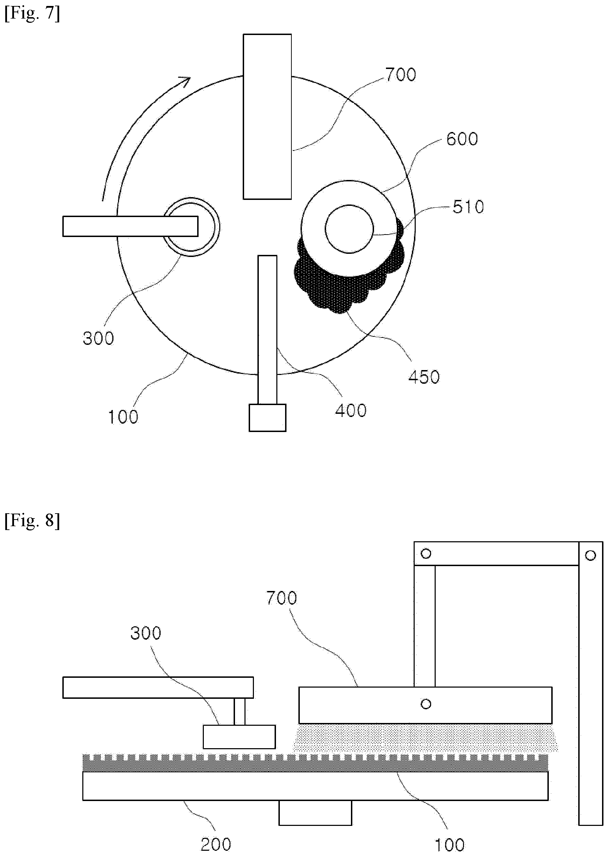

Figs. 7 and 8 show the configuration of a device for irradiating UV light during a CMP process according to an embodiment. Referring to Figs. 7 and 8, a UV lamp (700) is installed above a polishing pad (100) in the device according to an embodiment. The UV lamp may be configured to adjust angle and height. The UV lamp can irradiate light in a wavelength range of 100 nm to 380 nm to the polishing pad.

Fig. 2 shows the occurrence of a defect caused by debris during the process for preparing a semiconductor device. Referring to Fig. 2, debris (150) formed from the polishing layer may cause defects (650) or scratches on the surface of the semiconductor device. However, the polishing pad according to the embodiment has the feature of a reduced particle size of debris as UV light is irradiated during a CMP process. Thus, it is possible to minimize the occurrence of defects and scratches in semiconductor devices by irradiating UV light during a CMP process using these characteristics of the polishing pad. Therefore, when a semiconductor device is prepared using the polishing pad according to an embodiment through a CMP process, it is possible to enhance CMP performance and yield.

Hereinafter, the process for preparing a semiconductor device according to an embodiment will be described in detail.

First, once the polishing pad (100) according to an embodiment has been attached to a platen (200), a semiconductor substrate (600) as an object to be polished is disposed on the polishing pad (100). In such an event, the surface of the semiconductor substrate (600) to be polished is in direct contact with the polishing surface of the polishing pad (100). For polishing, a CMP slurry (450) may be supplied through a slurry supplier (400) onto the polishing pad. The flow rate of the CMP slurry (450) supplied through the slurry supplier (400) may be selected according to the purpose within a range of about 10 cm$^3$/minute to about 1,000 cm$^3$/minute. For example, it may be about 50 cm$^3$/minute to about 500 cm$^3$/minute, but it is not limited thereto.

Thereafter, the semiconductor substrate (600) and the polishing pad (100) rotate relatively to each other, so that the surface of the semiconductor substrate (600) is polished. In such an event, the rotation direction of the semiconductor substrate (600) and the rotation direction of the polishing pad (100) may be the same direction or opposite directions. The rotation speeds of the semiconductor substrate (600) and the polishing pad (100) may each be selected according to the purpose within a range of about 10 rpm to about 500 rpm. For example, it may be about 30 rpm to about 200 rpm, but it is not limited thereto.

The semiconductor substrate (600) mounted on the polishing head (510) is pressed against the polishing surface of the polishing pad (100) at a predetermined load to be in contact therewith, and the surface thereof may then be polished. The load applied to the polishing surface of the polishing pad (100) and the surface of the semiconductor substrate (600) by the polishing head (510) may be selected according to the purpose within a range of about 1 gf/cm$^2$ to about 1,000 gf/cm$^2$. For example, it may be about 10 gf/cm$^2$ to about 800 gf/cm$^2$, but it is not limited thereto.

In an embodiment, the semiconductor substrate (600) as an object to be polished may comprise an oxide layer, a tungsten layer, or a composite layer thereof. Specifically, the semiconductor substrate (600) may comprise an oxide layer, a tungsten layer, or a composite layer of an oxide layer and a tungsten layer. The composite layer of an oxide layer and a tungsten layer may be a multilayer film in which the tungsten layer is laminated on one side of the oxide layer or may be a single-layer film in which an oxide region and a tungsten region are mixed in a single layer. As the object to be polished has such a film substance, and, at the same time, the polishing pad has characteristics according to the embodiment, a semiconductor device fabricated according to the process for preparing a semiconductor device may have minimum defects.

In an embodiment, the process for preparing a semiconductor device may further comprise, in the step of polishing the object to be polished, supplying any one of a slurry for polishing an oxide layer and a slurry for polishing a tungsten layer; or sequentially supplying the slurry for polishing an oxide layer and the slurry for polishing a tungsten layer to the polishing surface.

For example, if the semiconductor substrate as an object to be polished comprises an oxide layer, the process for preparing a semiconductor device may comprise supplying a slurry for polishing an oxide layer. If the semiconductor substrate comprises a tungsten layer, the process for preparing a semiconductor device may comprise supplying a slurry for polishing a tungsten layer. If the semiconductor substrate comprises a composite layer of an oxide layer and a tungsten layer, the process for preparing a semiconductor device may comprise sequentially supplying a slurry for polishing an oxide layer and a slurry for polishing a tungsten layer to the polishing surface. Here, depending on the process, the slurry for polishing an oxide layer may be supplied first and then the slurry for polishing a tungsten layer may be supplied later, or the slurry for polishing a tungsten layer may be supplied first and then the slurry for polishing an oxide layer may be supplied later.

In an embodiment, in order to maintain the polishing surface of the polishing pad (100) in a state suitable for polishing, the process for preparing a semiconductor device may further comprise processing the polishing surface of the polishing pad (100) with a conditioner (300) simultaneously with polishing the semiconductor substrate (600).

In addition, the process for preparing a semiconductor device comprises conditioning the polishing layer of the polishing pad while irradiating UV light with a wavelength of 100 nm to 380 nm. In the device according to an embodiment, a UV lamp (700) is installed above a polishing pad (100). The UV lamp may be configured to adjust angle and height.

For example, the height of the UV lamp may be 2 cm to 30 cm, specifically, 3 cm to 10 cm, more specifically, 3 cm to 7 cm, from the surface of the polishing pad (100).

In addition, the intensity of UV light on the surface of the polishing pad (100) may be 100 W to 2 kW, more specifically, 500 W to 1.5 kW.

In addition, the irradiation time of UV light may be 1 minute or longer, 2 minutes or longer, or 3 minutes or longer, and 20 minutes or shorter, 10 minutes or shorter, 7 minutes or shorter, 5 minutes or shorter, or 4 minutes or shorter. For example, the irradiation time of UV light may be 1 minute to 20 minutes, 1 minute to 10 minutes, 2 minutes to 10 minutes, 1 minute to 7 minutes, 1 minute to 5 minutes, or 2 minutes to 5 minutes. As a specific example, the irradiation time of UV light may be 2 minutes to 4 minutes.

**Mode for the Invention**

Although the following examples are described, the scope of possible implementations is not limited thereto.

**A. Preparation and evaluation of a polishing pad**

**Examples A1 to A7 and Comparative Example A1 and A2: Preparation of a polishing pad**

Step (1) Preparation of a prepolymer

A four-necked flask was charged with toluene diisocyanate (TDI), dicyclohexylmethane diisocyanate (H12MDI), polytetramethylene ether glycol (PTMEG), and diethylene glycol (DEG), followed by reaction thereof at 80°C for 3 hours, thereby preparing a urethane-based prepolymer. The NCO% of the prepolymer was measured and is shown in Table 1 below.

Step (2) Preparation of a polishing pad

A casting machine equipped with tanks and feeding lines for the raw materials such as a prepolymer, a curing agent, an inert gas, and a foaming agent was provided. The urethane-based prepolymer prepared above, a foaming agent, a curing agent, an inert gas ($N_2$), and a silicone-based surfactant (Evonik) were each charged to the tanks. The raw materials were stirred while they were fed to the mixing head at constant rates through the respective feeding lines. The foaming agent and the curing agent listed in Table 1 below were used. The prepolymer and the curing agent were fed at an equivalent ratio of 1:1 and at a total rate of 10 kg/minute.

A mold (1,000 mm × 1,000 mm × 3 mm) was prepared and preheated at a temperature of 80°C. The mixed raw materials prepared above were injected into the mold and reacted to obtain a molded article in the form of a solid cake. Thereafter, the top and bottom of the molded article were each ground to obtain a polishing layer for a top pad.

Thereafter, the polishing layer was subjected to surface milling and groove-forming steps and laminated with a support layer for a sub pad by a hot melt adhesive, thereby preparing a polishing pad.

A double-sided adhesive tape (442JS, 3M) was laminated under the support layer so that it could be attached to the platen of CMP equipment.

The curing agent and the foaming agent used in the Examples and Comparative Examples are as follows.

- DMTDA: 3,5-dimethylthio-2,6-diaminotoluene, Covestro
- MOCA: 4,4'-methylene bis(2-chloroaniline), Ishihara
- F-65DE: acrylonitrile/methyl methacrylate/methacrylonitrile copolymer, expanded cell type, Matsumoto
- F-80DE: acrylonitrile/methyl methacrylate/methacrylonitrile copolymer, expanded cell type, Matsumoto
- 051DET40d25: acrylonitrile/methacrylonitrile copolymer, expanded cell type, Noury on
- 051DET40d42: acrylonitrile/methacrylonitrile copolymer, expanded cell type, Nouryon
- 461DET40d25: acrylonitrile/dichloroethane, expanded cell type, Nouryon

Details of the Examples and Comparative Examples are summarized in Table 1 below.

[Table 1]

| | | | Ex. A1 | Ex. A2 | Ex. A3 | Ex. A4 | Ex. A5 | Ex. A6 | Ex. A7 | C. Ex. A1 | C. Ex. A2 |
|---|---|---|---|---|---|---|---|---|---|---|---|
| Polishing layer | Prepolymer NCO% | | 10% | 10% | 10% | 10% | 10% | 10% | 10% | 10% | 10% |
| | Curing agent (weight ratio) | DMTDA | 100 | 100 | 100 | 99 | 96 | 90 | 86 | - | - |
| | | MOCA | - | - | - | 1 | 4 | 10 | 14 | 100 | 100 |
| | Solid phase foaming agent | | F-65DE | 051DET 40d25 | F-80DE | F-50D | 05 IDE T40d25 | F-80DE | F-50D | 051DET 40d42 | 461DET 40d25 |
| | Casting mold | | Single layer | Single layer | Single layer | Single layer | Single layer | Single layer | Single layer | Single layer | Single layer |
| | Casting, cutting, & Grooving* | | Seq. | Seq. | Seq. | Seq. | Seq. | Seq. | Seq. | Seq. | Seq. |
| | Prepolymer (part by weight) | | 100 | 100 | 100 | 100 | 100 | 100 | 100 | 100 | 100 |
| | Curing agent (part by weight) | | 32 | 32 | 32 | 32 | 32 | 32 | 32 | 32 | 32 |
| | Surfactant (part by weight) | | 1.0 | 1.0 | 1.0 | 1 | 1 | 1 | 1 | 1.0 | 1.0 |
| | Solid phase foaming agent (part by weight) | | 1.0 | 1.0 | 1.0 | 1 | 1 | 1 | 1 | 1.0 | 1.0 |
| | Inert gas (l/min) | | 1.5 | 1.5 | 1.5 | 1.5 | 1.5 | 1.5 | 1.5 | 1.5 | 1.5 |
| * Seq.: sequential | | | | | | | | | | | |

**Test Example A1**

The polishing layers, support layers, and polishing pads in which they had been laminated as prepared above were each tested as follows.

(1) Hardness

Each sample was cut to 5 cm × 5 cm (thickness: 2 mm) and stored at room temperature and a temperature of 30°C, 50°C, and 70°C, respectively, for 12 hours to measure the Shore D hardness and Asker C hardness using a hardness tester.

(2) Specific gravity

Each sample was cut to 2 cm × 5 cm (thickness: 2 mm) and stored at a temperature of 25°C for 12 hours to measure the specific gravity using a gravimeter.

(3) Tensile strength

Each sample was cut to 4 cm × 1 cm (thickness: 2 mm). The ultimate strength immediately before the fracture was measured while the sample was tested at a rate of 50 mm/minute using a universal testing machine (UTM).

(4) Elongation

Each sample was cut to 4 cm × 1 cm (thickness: 2 mm). The maximum deformation immediately before the fracture was measured while the sample was tested at a rate of 50 mm/min using a universal testing machine (UTM). The ratio of the maximum deformation to the initial length was expressed in percent (%).

The results are shown in the tables below.

[Table 2]

| | | Ex. A1 | Ex. A2 | Ex. A3 | Ex. A4 | Ex. A5 | Ex. A6 | Ex. A7 | C. Ex. A1 | C. Ex. A2 |
|---|---|---|---|---|---|---|---|---|---|---|
| Polishing layer | Thickness (mm) | 2 | 2 | 2 | 2 | 2 | 2 | 2 | 2 | 2 |
| | Hardness (Shore D) | 58.8 | 59.2 | 59.1 | 58.6 | 59.4 | 59.2 | 58.5 | 58.9 | 59.3 |
| | Specific gravity (g/cc) | 0.79 | 0.79 | 0.79 | 0.79 | 0.79 | 0.79 | 0.79 | 0.79 | 0.79 |
| | Tensile strength (N/mm$^2$) | 20.9 | 20.8 | 20.4 | 21 | 20.7 | 21.2 | 20.4 | 20.5 | 20.6 |
| | Elongation (%) | 111 | 108 | 109 | 105 | 101 | 103 | 102 | 101 | 109 |
| Support layer | Type* | NW fabric | NW fabric | NW fabric | NW fabric | NW fabric | NW fabric | NW fabric | NW fabric | NW fabric |
| | Thickness (mm) | 1.1 | 1.1 | 1.1 | 1.1 | 1.1 | 1.1 | 1.1 | 1.1 | 1.1 |
| | Hardness (Asker C) | 70 | 70 | 70 | 70 | 70 | 70 | 70 | 70 | 70 |

(continued)

| | | Ex. A1 | Ex. A2 | Ex. A3 | Ex. A4 | Ex. A5 | Ex. A6 | Ex. A7 | C. Ex. A1 | C. Ex. A2 |
|---|---|---|---|---|---|---|---|---|---|---|
| Laminated pad | Thickness (mm) | 3.32 | 3.32 | 3.32 | 3.32 | 3.32 | 3.32 | 3.32 | 3.32 | 3.32 |
| | Compression rate (%) | 1.05 | 1.05 | 1.05 | 1.05 | 1.05 | 1.05 | 1.05 | 1.05 | 1.05 |
| * NW fabric: nonwoven fabric | | | | | | | | | | |

As shown in the table above, the polishing pads of Examples A1 to A7 were at least equal to the polishing pads of Comparative Examples A1 and A2 in terms of hardness, specific gravity, tensile strength, and elongation.

**Test Example A2**

The polishing pads prepared above were each tested as follows.

(1) Polishing rate (removal rate)

A silicon wafer having a diameter of 300 mm on which silicon oxide had been deposited by a CVD process was set on the porous polyurethane polishing pad mounted on the platen in a CMP polishing machine, while the silicon oxide layer of the silicon wafer faced downward.

Then, the silicon oxide layer was polished under a polishing load of 4.0 psi while the polishing pad was rotated at a speed of 150 rpm, a calcined ceria slurry was supplied onto the polishing pad at a rate of 250 ml/minute, and the platen was rotated at a speed of 150 rpm for 60 seconds.

Upon completion of the polishing, the silicon wafer was detached from the carrier, mounted in a spin dryer, washed with deionized water (DIW), and then dried with nitrogen for 15 seconds. The film thickness of the dried silicon wafer was measured before and after the polishing using a spectral reflectometer-type thickness measuring instrument (manufacturer: Keyence, model: SI-F80R).

Thereafter, the polishing rate was calculated using the following Mathematical Equation 1.

Polishing rate (Å/minute) = difference in thickness before and after polishing (Å) / polishing time (minute)                    [mathematical equation 1]

(2) Defects

Polishing was carried out in the same manner as the polishing rate test using a CMP polishing machine. Upon completion of the polishing, the silicon wafer was transferred to a cleaner and cleaned for 10 seconds each using 1% HF, 1% $H_2NO_3$, and deionized water (DIW). Thereafter, it was transferred to a spin dryer, washed with deionized water (DIW), and then dried with nitrogen for 15 seconds. The change in defects of the dried silicon wafer before and after the polishing was measured using a defect measurement device (manufacturer: Tenkor, model: XP+). Specifically, the total number of scratches, chatter marks, pits, and residues on the surface of the wafer was measured.

(3) Chlorine content

A circular sample having a size of 3 cm in diameter and 0.3 cm in height was prepared from the polishing layer of the polishing pad. The content of chlorine in the sample was measured by IEC 62321-3-2, which is an international standard for measuring specific substances in a polymer by combustion-ion chromatography (C-IC).

(4) Debris size (D50 particle size)

a) Obtaining an aqueous solution of debris

A porous polyurethane polishing pad was attached to the platen of a CMP polishing machine. Thereafter, excluding the operation of the carrier, the debris of the polishing layer was collected using only the conditioner and deionized water (DIW). Conditioning of the polishing layer was carried out for a disc of CI45 (pad cut rate of 80 to 90 $\mu$m/hr, Saesol) while deionized water was supplied at 300 cc/minute under the conditions of a platen speed of 93 rpm, a conditioner load of 9 lbs, a rotation speed of 64 rpm, and a sweep speed of 19 times/minute. The debris of the polishing layer formed after 10 minutes of conditioning was collected in the form of a solution mixed with deionized water, thereby obtaining 300 mL of an aqueous solution of debris.

b) Adjustment of pH and analysis of the particle size of debris

The aqueous solution of debris had a pH at a level of 6.0 to 6.5, and the pH was adjusted to 5.5 using an aqueous nitric acid solution. Here, the concentration of the aqueous nitric acid solution used was 35%. The D50 particle size of debris in the aqueous solution of debris was measured using a particle size analyzer (Mastersize 3000, Malvern) and a medium-capacity automatic disperser (Hydro MV, Malvern). The analyzer was set with a polyurethane of 1.55 as the refractive index of a material to be analyzed, deionized water of 1.33 as the refractive index of a dispersant, and a stirring speed of 2,500 rpm.

(5) Zeta potential

An aqueous solution of debris was obtained in the same manner as in a) of section (4) above.
To ensure particle stability in the aqueous solution of debris, it was stored at room temperature for 24 hours to precipitate particles with a particle diameter of 20 $\mu$m or more. Thereafter, the supernatant located within 10 mm from the top surface of the solution was then taken as a sample. The sample obtained had a pH at a level of 6.0 to 6.5. The pH was adjusted to 5.5 using an aqueous nitric acid solution. Here, the concentration of the aqueous nitric acid solution used was 35%. In addition, the concentration of debris in the liquid sample was found to be about 0.01% by weight. The concentration was measured using a heated moisture meter (MX-50, AND) after placing about 5 g of a liquid sample in an aluminum dish. The zeta potential of the sample was measured using a zetasizer (Nano-ZS90, Malvern). Specifically, 1 mL of the sample was charged to the cuvette of the zetasizer and measured three times to obtain the zeta potential. In such an event, the equipment setting value was set to RI 1.550 and Absorption 0.010 based on the polyurethane value.
The test results are summarized in the following table.

[Table 3]

| | Unit | Ex. A1 | Ex. A2 | Ex. A3 | Ex. A4 | Ex. A5 | Ex. A6 | Ex. A7 | C. Ex. A1 | C. Ex. A2 |
|---|---|---|---|---|---|---|---|---|---|---|
| Cl content | ppm | 36 | 32 | 33 | 500 | 2,000 | 5,000 | 7,000 | 28,614 | 54,786 |
| Polishing rate of an oxide film with a ceria slurry | Å/min | 2,412 | 2,388 | 2,398 | 2,379 | 2,415 | 2,422 | 2,392 | 2,403 | 2,401 |
| Defect/scratch | count | 5 | 7 | 3 | 8 | 14 | 13 | 15 | 25 | 28 |
| Debris particle size (pH 5.5) | $\mu$m | 17.1 | 16.8 | 16.5 | 18.1 | 19.2 | 19.6 | 21 | 25.2 | 27.3 |
| Zeta potential (pH 5.5) | mV | 9.2 | 12.5 | 8.1 | 6.2 | 3.2 | 1.3 | -4 | -23.1 | -24.7 |

As can be seen from the table above, the polishing pads of Examples A1 to A7 were measured with a chlorine (Cl) content within the desirable range, and the performance thereof such as polishing rate was equal to, or higher than, that of Comparative Examples A1 and A2. In particular, the particle size of debris of the polishing pads of Examples A1 to A7 was measured to be smaller than that of Comparative Examples A1 and A2, and the number of defects and scratches was measured to be significantly lower. In addition, the zeta potential of the polishing pads of Examples A1 to A7 was measured to be within the desirable range.

(6) Debris size and zeta potential with respect to changes in pH

For the polishing pads of the Examples and Comparative Examples, the debris particle size (D50 [5.5]) at a pH of 5.5 and the debris particle size (D50 [10]) at a pH of 10 were measured in the same manner as in section (4) above.
In addition, for the polishing pads of the Examples and Comparative Examples, the zeta potential of the aqueous solution of debris (Zp [5.5]) at a pH of 5.5 and the zeta potential of the aqueous solution of debris (Zp [10]) at a pH of 10 were measured in the same manner as in section (5) above.
Here, the pH of the aqueous solution of debris was adjusted by adding an aqueous nitric acid solution or an aqueous potassium hydroxide solution. Specifically, when the aqueous solution of debris initially obtained (pH 6.0 to 6.5) was adjusted to a pH of 5.5, an aqueous nitric acid solution was added, and when it was adjusted to a pH of 10, an aqueous potassium hydroxide solution was added. Here, the concentration of the aqueous nitric acid solution used was 35%, and the concentration of the aqueous potassium hydroxide solution was 10%.

The following Equations (1) to (3) were calculated using the debris size and zeta potential measured above.

$$D50\ [5.5]\ /\ Zp\ [5.5]\ ...\ (1)$$

$$(D50\ [5.5]\ /\ D50\ [10])\times 100\ ...\ (2)$$

$$Zp\ [5.5]-Zp\ [10]\ ...\ (3)$$

Here, D50 [5.5] is the D50 particle size ($\mu$m) of debris obtained during conditioning of the polishing layer at a pH of 5.5, and D50 [10] is the D50 particle size ($\mu$m) of debris obtained during conditioning of the polishing layer at a pH of 10.

Zp [5.5] is the zeta potential (mV) of an aqueous solution containing debris obtained during conditioning of the polishing layer at a concentration of 0.01% by weight at a pH of 5.5, and Zp [10] is the zeta potential (mV) of an aqueous solution containing debris obtained during conditioning of the polishing layer at a concentration of 0.01% by weight at a pH of 10.

The results are shown in the tables below.

In addition, the test results of defects and scratches are shown in the Table below as well.

[Table 4]

| | Description | Unit | Ex. A1 | Ex. A2 | Ex. A3 | Ex. A4 | Ex. A5 | Ex. A6 | Ex. A7 | C. Ex. A1 | C. Ex. A2 |
|---|---|---|---|---|---|---|---|---|---|---|---|
| D50 [5.5] | Debris particle size (pH 5.5) | $\mu$m | 17.1 | 16.8 | 16.5 | 18.1 | 19.2 | 19.6 | 21 | 25.2 | 27.3 |
| D50 [10] | Debris particle size (pH 10) | $\mu$m | 22 | 20.5 | 21.4 | 21.5 | 21.8 | 21.9 | 22.3 | 22.4 | 23.3 |
| Zp [5.5] | Zeta potential (pH 5.5) | mV | 9.2 | 12.5 | 8.1 | 6.2 | 3.2 | 1.3 | -4 | -23.1 | -24.7 |
| Zp [10] | Zeta potential (pH 10) | mV | -27.2 | -35.7 | -31.0 | -40.7 | -41.2 | -41.8 | -42.6 | -51.3 | -59.8 |
| Equation (1) | D50 [5.5] / Zp [5.5] | $\mu$m/mV | 1.86 | 1.34 | 2.04 | 2.92 | 6.00 | 15.08 | -5.25 | -1.09 | -1.11 |
| Equation (2) | (D50 [5.5] / D50 [10]) $\times$ 100 | % | 77.73 | 81.95 | 77.10 | 84.19 | 88.07 | 89.50 | 94.17 | 112.50 | 117.17 |
| Equation (3) | Zp [5.5] - Zp [10] | mV | 36.40 | 48.20 | 39.10 | 46.90 | 44.40 | 43.10 | 38.60 | 28.20 | 35.10 |
| Evaluation | Defect/scratch | count | 5 | 7 | 3 | 8 | 14 | 13 | 15 | 25 | 28 |

As can be seen from the above table, for the polishing pads of Examples A1 to A7, the D50 particle size of the debris obtained from the polishing layer was 50 $\mu$m or less at a pH of 5.5, and the zeta potential of the aqueous solution of debris was measured to be within the range of -20 mV to 30 mV at a pH of 5.5. In addition, for the polishing pads of Examples A1 to A7, the measured values under different pH conditions and the values of Equations (1) to (3) were all within the desirable ranges. As a result, the number of defects and scratches that occurred on the silicon wafer during the CMP process was less than 20.

In particular, for the polishing pads of Examples A1 to A3, the D50 particle size of the debris obtained from the polishing layer was 20 $\mu$m or less at a pH of 5.5, and the zeta potential of the aqueous solution of debris was measured to be within the range of 0 mV to 20 mV at a pH of 5.5. In addition, for the polishing pads of Examples A1 to A3, the measured values under different pH conditions and the values of Equations (1) to (3) were all within the desirable ranges. As a result, the number of defects and scratches that occurred on the silicon wafer during the CMP process was very small, less than 10.

In contrast, for the polishing pads of Comparative Examples A1 and A2, the zeta potential value of the aqueous solution of debris obtained from the polishing layer was measured to be less than -20 mV at a pH of 5.5. The other measured values and the values of Equations (1) to (3) were also confirmed to be outside the desirable ranges. As a result, the number of defects and scratches that occurred on the silicon wafer during the CMP process was significantly increased to 25 or more.

## B. Preparation of a polishing pad and evaluation thereof when irradiated with UV

### Example B1: Preparation of a polishing pad

Step (1) Preparation of a urethane-based prepolymer

A four-necked flask was charged with 2,4-toluene diisocyanate (2,4-TDI), 2,6-toluene diisocyanate (2,6-TDI), dicyclohexylmethane diisocyanate (H12MDI), polytetramethylene ether glycol (PTMEG), and diethylene glycol (DEG), followed by reaction thereof at 80°C for 3 hours, thereby preparing a urethane-based prepolymer having a content of terminal NCO groups (NCO%) of 10% by weight.

Step (2) Preparation of a polishing layer

A casting machine equipped with tanks and feeding lines for the raw materials such as a prepolymer, a curing agent, an inert gas, and a foaming agent was provided. The urethane-based prepolymer prepared above, a curing agent (DMTDA), a solid phase foaming agent (F-65DE, Matsumoto), an inert gas ($N_2$), and a silicone-based surfactant (Evonik) were each charged to the tanks. Specifically, 32 parts by weight of the curing agent, 1 part by weight of the solid phase foaming agent, and 1 part by weight of the surfactant were charged relative to 100 parts by weight of the prepolymer, and the inert gas was fed at 1.5 L/minute.
The raw materials were stirred while they were fed to the mixing head at constant rates through the respective feeding lines. The rotation speed of the mixing head was about 5,000 rpm. The mixture composition of the raw materials mixed in the mixing head was then injected into a mold having a width of 1,000 mm, a length of 1,000 mm, and a height of 3 mm. The temperature of the mold was adjusted to about 80 ($\pm$5)°C. The mixture composition was solidified in the mold to be cast into a sheet. The sheet was post-cured at about 110 ($\pm$5)°C for about 18 hours to prepare a polishing layer.

Step (3) Preparation of a polishing pad

One side of the polishing layer was subjected to line turning using a cutting tool and grooved using a tip to have an average thickness of 2 mm. A polyester fiber nonwoven fabric was impregnated with a polyurethane resin to prepare a cushion layer. A heat-sealing adhesive was applied to one side of the cushion layer and to the side of the polishing layer opposite to the polishing surface, respectively. The cushion layer and the polishing layer were laminated such that the sides to which the heat-sealing adhesive had been applied were in contact, which was then pressed using a pressing roller at a temperature of about 140 ($\pm$5)°C and a pressure of 2 kgf/cm$^2$ to prepare a polishing pad.

### Comparative Example B1: Preparation of a polishing pad

Step (1) Preparation of a urethane-based prepolymer

A four-necked flask was charged with 2,4-toluene diisocyanate (2,4-TDI), 2,6-toluene diisocyanate (2,6-TDI), dicyclohexylmethane diisocyanate (H12MDI), polytetramethylene ether glycol (PTMEG), and diethylene glycol (DEG), followed by reaction thereof at 80°C for 3 hours, thereby preparing a urethane-based prepolymer having a content of terminal NCO groups (NCO%) of 9.1% by weight.

Step (2) Preparation of a polishing layer

A casting machine equipped with tanks and feeding lines for the raw materials such as a prepolymer, a curing agent, an inert gas, and a foaming agent was provided. The urethane-based prepolymer prepared above, a curing agent (4,4'-methylenebis(2-chloroaniline), MOCA), a solid phase foaming agent (Expancel™ 551 DE 40 d42, Akzonobel), an inert gas ($N_2$), and a silicone-based surfactant (Evonik) were each charged to the tanks. Specifically, 25 parts by weight of the curing agent, 2.2 parts by weight of the solid phase foaming agent, and 1 part by weight of the surfactant were charged relative to 100 parts by weight of the prepolymer, and the inert gas was fed at 1.5 L/minute.
The raw materials were stirred while they were fed to the mixing head at constant rates through the respective feeding lines. The rotation speed of the mixing head was about 5,000 rpm. The mixture composition of the raw materials mixed in the mixing head was then injected into a mold having a width of 1,000 mm, a length of 1,000 mm, and a height of 3 mm. The temperature of the mold was adjusted to about 80 ($\pm$5)°C. The mixture composition was solidified in the mold to be cast into a sheet. The sheet was post-cured at about 110 ($\pm$5)°C for about 18 hours to prepare a polishing layer.

Step (3) Preparation of a polishing pad

One side of the polishing layer was subjected to line turning using a cutting tool and grooved using a tip to have an average thickness of 2 mm. A polyester fiber nonwoven fabric was impregnated with a polyurethane resin to prepare a cushion layer. A heat-sealing adhesive was applied to one side of the cushion layer and to the side of the polishing layer opposite to the polishing surface, respectively. The cushion layer and the polishing layer were laminated such that the sides to which the heat-sealing adhesive had been applied were in contact, which was then pressed using a pressing roller at a temperature of about 140 ($\pm$5)°C and a pressure of 2 kgf/cm$^2$ to prepare a polishing pad.

**Test Example B1: Measurement of the physical properties of the polishing pad**

The polishing layers, support layers, and polishing pads in which they had been laminated as prepared above were each tested as follows.

(1) Hardness

Each sample was cut to 5 cm × 5 cm (thickness: 2 mm) and stored at room temperature and a temperature of 30°C, 50°C, and 70°C, respectively, for 12 hours to measure the Shore D hardness and Asker C hardness using a hardness tester.

(2) Specific gravity

Each sample was cut to 2 cm × 5 cm (thickness: 2 mm) and stored at a temperature of 25°C for 12 hours to measure the specific gravity using a gravimeter.

(3) Tensile strength

Each sample was cut to 4 cm × 1 cm (thickness: 2 mm). The ultimate strength immediately before the fracture was measured while the sample was tested at a rate of 50 mm/minute using a universal testing machine (UTM).

(4) Elongation

Each sample was cut to 4 cm × 1 cm (thickness: 2 mm). The maximum deformation immediately before the fracture was measured while the sample was tested at a rate of 50 mm/min using a universal testing machine (UTM). The ratio of the maximum deformation to the initial length was expressed in percent (%).
The results are shown in the tables below.

[Table 5]

|  |  | Example B1 |
|---|---|---|
| Polishing layer | Thickness (mm) | 2 |
|  | Hardness (Shore D) | 58.8 |
|  | Specific gravity (g/cc) | 0.79 |
|  | Tensile strength (N/mm$^2$) | 20.9 |
|  | Elongation (%) | 111 |
| Support layer | Type | Nonwoven fabric |
|  | Thickness (mm) | 1.1 |
|  | Hardness (Asker C) | 70 |

(continued)

|  |  | Example B1 |
|---|---|---|
| Laminated pad | Thickness (mm) | 3.32 |
|  | Compression rate (%) | 1.05 |

As can be seen from the above table, the polishing pad of Example B 1 was confirmed to have properties suitable for a CMP process.

**Test Example B2: Changes in debris size with UV irradiation**

(1) Conditioning process

A porous polyurethane polishing pad was attached to the platen of a CMP polishing machine. Thereafter, excluding the operation of the carrier, the debris of the polishing layer was collected using only the conditioner and a ceria slurry. Conditioning of the polishing layer was carried out for a disc of CI45 (pad cut rate of 80 to 90 $\mu$m/hr, Saesol) while a ceria slurry was supplied at 250 mL/minute under the conditions of a platen speed of 93 rpm, a conditioner load of 9 lbs, a rotation speed of 64 rpm, and a sweep speed of 19 times/minute. The debris of the polishing layer formed after 10 minutes of conditioning was collected in the form of a solution mixed with a ceria slurry, thereby obtaining 300 mL of a debris solution.

(2) UV irradiation

While the obtained debris solution was irradiated with UV light (wavelength 100 to 380 nm) at an intensity of 1 kW for 10 minutes from a distance of 5 cm using a UV lamp (type of light source: mercury lamp), the debris solution was collected at 2-minute intervals. In such an event, the collected debris solution had a pH of about 10.

(4) Analysis of the debris particle size

The D50 particle size of debris in the debris solution was measured using a particle size analyzer (Mastersize 3000, Malvern) and a medium-capacity automatic disperser (Hydro MV, Malvern). The analyzer was set with a polyurethane of 1.55 as the refractive index of a material to be analyzed, deionized water of 1.33 as the refractive index of a dispersant, and a stirring speed of 2,500 rpm.

The results are shown in Figs. 5 and 6 and Tables 6 and 7 below.

[Table 6]

| Example B1 | Debris particle size ($\mu$m) | | |
|---|---|---|---|
|  | D10 | D50 | D90 |
| 0 minute | 11.9 | 40.1 | 176.0 |
| 2 minutes | 8.6 | 25.4 | 49.7 |
| 4 minutes | 7.3 | 25.3 | 47.9 |
| 6 minutes | 10.7 | 33.0 | 148.0 |
| 8 minutes | 10.4 | 32.2 | 92.2 |

[Table 7]

| C. Ex. B1 | Debris particle size ($\mu$m) | | |
|---|---|---|---|
|  | D10 | D50 | D90 |
| 0 minute | 14.2 | 31.7 | 62.4 |
| 2 minutes | 13.8 | 29.3 | 52.4 |
| 4 minutes | 15.9 | 35.6 | 68.5 |
| 6 minutes | 15.6 | 37.8 | 75.5 |

(continued)

| C. Ex. B1 | Debris particle size (μm) | | |
|---|---|---|---|
| | D10 | D50 | D90 |
| 8 minutes | 14.9 | 32.6 | 58.6 |
| 10 minutes | 17.3 | 55.8 | 112.0 |

As can be seen from Tables 6 and 7 above and Figs. 5 and 6, for the polishing pad according to Example B1, the debris particle size decreased as the irradiation time with UV light elapsed, which was measured to be the smallest at 2 to 4 minutes. Thereafter, a trend of slight increase was shown when the irradiation time with UV light further elapsed to 6 to 8 minutes. Overall, the debris particle size tended to decrease as the irradiation time with UV light elapsed.

On the other hand, the polishing pad according to Comparative Example B 1 showed a tendency for the debris particle size to generally increase as the irradiation time with UV light elapsed. It was measured to be increased almost twice when 10 minutes elapsed as compared with the initial stage.

**Test Example B3: Evaluation of the performance of the polishing pad (CMP and UV irradiation)**

As shown in Figs. 7 and 8, a UV lamp (700) whose angle and height are adjustable was installed in a CMP polishing machine. A silicon wafer having a diameter of 300 mm on which silicon oxide had been deposited by a CVD process was set on the porous polyurethane polishing pad mounted on the platen in the CMP polishing machine, while the silicon oxide layer of the silicon wafer faced downward. Then, the silicon oxide layer was polished under a polishing load of 4.0 psi while the polishing pad was rotated at a speed of 150 rpm, a calcined ceria slurry was supplied onto the polishing pad at a rate of 250 ml/minute, and the platen was rotated at a speed of 150 rpm for 60 seconds. During CMP polishing, the UV lamp (700) was activated to irradiate the surface of the polishing layer of the polishing pad with UV light (wavelength 100 to 380 nm) from a distance of 5 cm at an intensity of 1 kW.

(1) Polishing rate (removal rate)

Similarly to the above, upon completion of the polishing, the silicon wafer was detached from the carrier, mounted in a spin dryer, washed with deionized water (DIW), and then dried with nitrogen for 15 seconds. The film thickness of the dried silicon wafer was measured before and after the polishing using a spectral reflectometer-type thickness measuring instrument (manufacturer: Keyence, model: SI-F80R).

Thereafter, the polishing rate was calculated using the following Mathematical Equation 1.

Polishing rate (Å/minute) = difference in thickness before and after polishing (Å) / polishing time (minute)     [mathematical equation 1]

(2) Defects

Polishing was carried out in the same manner as the polishing rate test using a CMP polishing machine. Upon completion of the polishing, the silicon wafer was transferred to a cleaner and cleaned for 10 seconds each using 1% HF, 1% $H_2NO_3$, and deionized water (DIW). Thereafter, it was transferred to a spin dryer, washed with deionized water (DIW), and then dried with nitrogen for 15 seconds. The change in defects of the dried silicon wafer before and after the polishing was measured using a defect measurement device (manufacturer: Tenkor, model: XP+). Specifically, the total number of scratches, chatter marks, pits, and residues on the surface of the wafer was measured.

(3) Pad wear rate (PWR)

Each polishing pad was pre-conditioned with deionized water for 10 minutes in the initial stage and then conditioned while deionized water was sprayed for 1 hour. In such an event, the changes in thickness were measured during conditioning for 1 hour. The equipment used for conditioning was AP-300HM of CTS. The conditioning pressure was 6 lbf, the rotation speed was 100 to 110 rpm, and the disk used for conditioning was CI-45 of Sasol.

[Table 8]

| | Unit | Ex. B1 | C. Ex. B1 |
|---|---|---|---|
| Polishing rate of oxide film with ceria slurry | Å/min | 2015.9 | 2282.3 |

(continued)

|  | Unit | Ex. B1 | C. Ex. B1 |
|---|---|---|---|
| Defect/scratch | count | 6/5 | 8/8 |
| Pad wear rate | μm/hr | 21.3 | 22.7 |

As a result of the test, the polishing pad of the Example had both a polishing rate and a pad wear rate within the desirable ranges and had very few defects. Meanwhile, the polishing pad of the Comparative Example had a polishing rate outside the desired range, and the occurrence of defects increased.

[Reference Numeral of the Drawings]

| 100: | polishing pad | | | 150: | debris |
|---|---|---|---|---|---|
| 200: | platen | | | 300: | conditioner |
| 400: | slurry supplier | | | | |
| 450: | polishing slurry (CMP slurry) | | | 510: | polishing head |
| 520: | carrier | | | 600: | semiconductor substrate (wafer) |
| 650: | defect | 700: | UV lamp | 750: | UV light |

## Claims

1. A polishing pad, which comprises a polishing layer, wherein the polishing layer comprises a urethane-based prepolymer, a foaming agent, and a curing agent; when the polishing layer is conditioned for 10 minutes while deionized water is supplied at 300 cc/minute under the conditions of a platen speed of 93 rpm, a conditioner load of 9 lbs, a conditioner speed of 64 rpm, and a sweep of 19 times/minute, the D50 particle size of the debris obtained is 50 μm or less at a pH of 5.5; and the zeta potential of an aqueous solution containing the debris at a concentration of 0.01% by weight is -20 mV to 30 mV at a pH of 5.5.

2. The polishing pad of claim 1, wherein the D50 particle size of the debris obtained during conditioning of the polishing layer is 25 μm or less at a pH of 5.5 and 22.3 μm or less at a pH of 10.

3. The polishing pad of claim 1 or claim 2, wherein the zeta potential of an aqueous solution containing debris obtained when the polishing layer is conditioned for 10 minutes at a concentration of 0.01% by weight is -50 mV to -10 mV at a pH of 10.

4. The polishing pad of any preceding claim, wherein the value of the following Equation (1) is -10 μm/mV to 20 μm/mV:

$$D50\ [5.5] / Zp\ [5.5] ... (1)$$

wherein D50 [5.5] is the D50 particle size (μm) of debris obtained during conditioning of the polishing layer at a pH of 5.5, and Zp [5.5] is the zeta potential (mV) of an aqueous solution containing debris obtained during conditioning of the polishing layer at a concentration of 0.01% by weight at a pH of 5.5.

5. The polishing pad of any preceding claim, wherein the value of the following Equation (2) is 70% to 110%:

$$(D50\ [5.5] / D50\ [10]) \times 100 ... (2)$$

wherein D50 [5.5] is the D50 particle size (μm) of debris obtained during conditioning of the polishing layer at a pH of 5.5, and D50 [10] is the D50 particle size (μm) of debris obtained during conditioning of the polishing layer at a pH of 10.

6. The polishing pad of any preceding claim, wherein, when the silicon oxide layer of a silicon wafer is polished with a ceria slurry using the polishing pad, the polishing rate according to the following Mathematical Equation 1 is 2,200 Å/minute to 2,600 Å/minute:

Polishing rate (Å/minute) = difference in thickness before and after polishing (Å) / polishing time (minute)　　　　　　　　　　[mathematical equation 1]

7.　A polishing pad, which comprises a polishing layer comprising a polyurethane resin, wherein, when the polishing layer is conditioned while a ceria slurry is supplied at 250 ml/minute under the conditions of a platen speed of 93 rpm, a conditioner load of 9 lbs, a conditioner speed of 64 rpm, and a sweep of 19 times/minute, followed by irradiation with UV light with a wavelength of 100 nm to 380 nm at an intensity of 1 kW from a distance of 5 cm, the debris obtained satisfies the following Relationship (1):

$$D50 \ [0 \ min] > D50 \ [4 \ min] \ ... \ (1)$$

wherein D50 [0 min] is the D50 particle size of the debris obtained in the conditioning before the irradiation with UV light, and D50 [4 min] is the D50 particle size of the debris obtained upon the irradiation with UV light for 4 minutes after the conditioning.

8.　The polishing pad of claim 7, wherein $\Delta$D50 [0-4 min] calculated according to the following equation is 10 $\mu$m or more:

$$\Delta D50 \ [0\text{-}4 \ min] = D50 \ [0 \ min] - D50 \ [4 \ min]$$

wherein D50 [0 min] is the D50 particle size of the debris obtained in the conditioning before the irradiation with UV light, and D50 [4 min] is the D50 particle size of the debris obtained upon the irradiation with UV light for 4 minutes after the conditioning.

9.　The polishing pad of claim 7 or claim 8, wherein D50 [4 min] is 30 $\mu$m or less.

10.　The polishing pad of any of claims 7-9, wherein the polishing pad satisfies the following Relationship (2):

$$D50 \ [4 \ min] < D50 \ [8 \ min] \ ... \ (2)$$

wherein D50 [4 min] is the D50 particle size of the debris obtained upon the irradiation with UV light for 4 minutes after the conditioning, and D50 [8 min] is the D50 particle size of the debris obtained upon the irradiation with UV light for 8 minutes after the conditioning.

11.　The polishing pad of any of claims 7-10, wherein the polishing pad satisfies the following Relationship (3):

$$(D90 \ [0 \ min] - D10 \ [0 \ min]) > (D90 \ [4 \ min] - D10 \ [4 \ min]) \ ... \ (3)$$

wherein D10 [0 min] and D90 [0 min] are each the D10 and D90 particle sizes of the debris obtained in the conditioning before the irradiation with UV light, and D10 [4 min] and D90 [4 min] are each the D10 and D90 particle sizes of the debris obtained upon the irradiation with UV light for 4 minutes after the conditioning.

12.　The polishing pad of any of claims 7-11, wherein, when the silicon oxide layer of a silicon wafer is polished with a ceria slurry using the polishing pad, while irradiated with UV light with a wavelength of 100 nm to 380 nm at an intensity of 1 kW from a distance of 5 cm, the polishing rate according to the following Mathematical Equation 1 is 1,800 Å/minute to 2,200 Å/minute:

Polishing rate (Å/minute) = difference in thickness before and after polishing (Å) / polishing time (minute)　　　　　　　　　　[mathematical equation 1]

13. The polishing pad of any of claims 7-12, wherein, when the polishing pad is tested at a conditioning pressure of 6 lbf and a rotation speed of 100 to 110 rpm, the pad wear rate (PWR) is 15 $\mu$m/hr to 40 $\mu$m/hr.

14. A process for preparing a semiconductor device, which comprises polishing the surface of a semiconductor substrate using the polishing pad of any of claims 1-6.

15. A process for preparing a semiconductor device, which comprises conditioning the polishing layer of the polishing pad with irradiation of UV light with a wavelength of 100 nm to 380 nm while chemically and mechanically polishing a semiconductor substrate using the polishing pad of any of claims 7-13.

[Fig. 1]

[Fig. 2]

[Fig. 3]

```
┌─────────────────────────┐
│      Polishing pad      │
└─────────────────────────┘
             │  Conditioning
             │  (deionized water)
             ▼
┌─────────────────────────┐
│        Debris +         │
│     deionized water     │
└─────────────────────────┘
             │  Adjustment of pH
             ▼
┌─────────────────────────┐        Measurement of
│     Debris solution     │ ────▶  debris particle size
│        (pH 5.5)         │
└─────────────────────────┘
```

[Fig. 4]

```
┌─────────────────────────┐
│      Polishing pad      │
└─────────────────────────┘
             │  Conditioning
             │  (deionized water)
             ▼
┌─────────────────────────┐
│        Debris +         │
│     deionized water     │
└─────────────────────────┘
             │  Precipitation of
             │  particles
             ▼
┌─────────────────────────┐
│       Supernatant       │
└─────────────────────────┘
             │  Adjustment of pH
             ▼
┌─────────────────────────┐        Measurement of
│     Debris solution     │ ────▶  zeta potential
│        (pH 5.5)         │
└─────────────────────────┘
```

[Fig. 5]

[Fig. 6]

[Fig. 7]

[Fig. 8]

Europäisches Patentamt
European Patent Office
Office européen des brevets

# EUROPEAN SEARCH REPORT

**Application Number**

EP 24 19 1275

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/059401 A1 (YUN JONG WOOK [KR] ET AL) 24 February 2022 (2022-02-24) | 1-14 | INV. B24B37/24 B24B53/017 |
| A | * paragraphs [0050] - [0076], [0090], [0129] - [0131]; claims 5,9,17,19; figure 4 * | 15 | |
| X | EP 1 489 652 A2 (MINNESOTA MINING & MFG [US]) 22 December 2004 (2004-12-22) | 1-14 | |
| A | * paragraphs [0005], [0082] - [0085], [0106] - [0111], [0244], [0245], [0275], [0277]; claims 16,17; figure 3 * | 15 | |
| A | EP 3 608 378 A1 (VERSUM MAT US LLC [US]) 12 February 2020 (2020-02-12) * paragraphs [0028], [0031], [0032], [0045], [0049], [0054], [0082], [0086], [0092], [0093]; claim 13 * | 1-15 | |
| A | CN 115 960 540 A (ANST TECH SHENZHEN CO LTD) 14 April 2023 (2023-04-14) * abstract * | 1-15 | |

**TECHNICAL FIELDS SEARCHED (IPC)**

B24B

The present search report has been drawn up for all claims

| Place of search | Date of completion of the search | Examiner |
|---|---|---|
| Munich | 10 September 2024 | Kornmeier, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 19 1275

This annex lists the patent family members relating to the patent documents cited in the above-mentioned European search report.
The members are as contained in the European Patent Office EDP file on
The European Patent Office is in no way liable for these particulars which are merely given for the purpose of information.

10-09-2024

| Patent document cited in search report | | Publication date | Patent family member(s) | | Publication date |
|---|---|---|---|---|---|
| US 2022059401 | A1 | 24-02-2022 | CN | 114083432 A | 25-02-2022 |
| | | | EP | 3960369 A1 | 02-03-2022 |
| | | | JP | 7239653 B2 | 14-03-2023 |
| | | | JP | 2022036931 A | 08-03-2022 |
| | | | JP | 2023078197 A | 06-06-2023 |
| | | | TW | 202222493 A | 16-06-2022 |
| | | | US | 2022059401 A1 | 24-02-2022 |
| EP 1489652 | A2 | 22-12-2004 | NONE | | |
| EP 3608378 | A1 | 12-02-2020 | CN | 110819238 A | 21-02-2020 |
| | | | CN | 110857380 A | 03-03-2020 |
| | | | EP | 3608378 A1 | 12-02-2020 |
| | | | EP | 3608379 A1 | 12-02-2020 |
| | | | JP | 7469006 B2 | 16-04-2024 |
| | | | JP | 2020026532 A | 20-02-2020 |
| | | | JP | 2020029554 A | 27-02-2020 |
| | | | KR | 20200018338 A | 19-02-2020 |
| | | | KR | 20200018339 A | 19-02-2020 |
| | | | SG | 10201907379W A | 30-03-2020 |
| | | | SG | 10201907380R A | 30-03-2020 |
| | | | TW | 202009286 A | 01-03-2020 |
| | | | TW | 202009287 A | 01-03-2020 |
| | | | US | 2020048496 A1 | 13-02-2020 |
| | | | US | 2020048551 A1 | 13-02-2020 |
| CN 115960540 | A | 14-04-2023 | CN | 115960540 A | 14-04-2023 |
| | | | TW | 202423617 A | 16-06-2024 |
| | | | WO | 2024130991 A1 | 27-06-2024 |
| | | | WO | 2024131734 A1 | 27-06-2024 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 20160027075